(19) Europäisches Patentamt / European Patent Office / Office européen des brevets

(11) **EP 2 397 873 A1**

(12) **EUROPEAN PATENT APPLICATION**
published in accordance with Art. 153(4) EPC

(43) Date of publication:
**21.12.2011 Bulletin 2011/51**

(51) Int Cl.:
***G02B 5/28*** (2006.01)     ***C23C 14/06*** (2006.01)
***G02B 5/22*** (2006.01)

(21) Application number: **10741175.3**

(22) Date of filing: **04.02.2010**

(86) International application number:
**PCT/JP2010/051620**

(87) International publication number:
**WO 2010/092898 (19.08.2010 Gazette 2010/33)**

(84) Designated Contracting States:
**AT BE BG CH CY CZ DE DK EE ES FI FR GB GR
HR HU IE IS IT LI LT LU LV MC MK MT NL NO PL
PT RO SE SI SK SM TR**

(30) Priority:   **13.02.2009   JP 2009031634
13.02.2009   JP 2009031637
13.02.2009   JP 2009031638**

(71) Applicant: **Panasonic Electric Works Co., Ltd.
Kadoma-shi
Osaka 571-8686 (JP)**

(72) Inventors:
• **HIRAI, Takahiko
Kadoma-shi
Osaka 571-8686 (JP)**
• **KITAMURA, Hiroaki
Kadoma-shi
Osaka 571-8686 (JP)**

• **INABA, Yuichi
Kadoma-shi
Osaka 571-8686 (JP)**
• **WATABE, Yoshifumi
Kadoma-shi
Osaka 571-8686 (JP)**
• **NISHIKAWA, Takayuki
Kadoma-shi
Osaka 571-8686 (JP)**
• **SONO, Takahiro
Kadoma-shi
Osaka 571-8686 (JP)**

(74) Representative: **Appelt, Christian W.
Forrester & Boehmert
Pettenkoferstrasse 20-22
80336 München (DE)**

(54)   **INFRARED OPTICAL FILTER AND METHOD FOR PRODUCING SAME**

(57)   The infrared optical filter of the present invention comprises a substrate formed of an infrared transmitting material and a plurality of filter parts arranged side by side on one surface side of the substrate. Each filter part includes: a first $\lambda/4$ multilayer film in which two kinds of thin films having mutually different refractive indices but an identical optical film thickness are alternately stacked; a second $\lambda/4$ multilayer film in which the two kinds of thin films are alternately stacked, said second $\lambda/4$ multilayer film being formed on the opposite side of the first $\lambda/4$ multilayer film from the substrate side, and ; and a wavelength selection layer interposed between the first $\lambda/4$ multilayer film and the second $\lambda/4$ multilayer film, said wavelength selection layer having an optical film thickness different from the optical film thickness of each the thin film according to a desired selection wavelength. A low refractive index material of the first $\lambda/4$ multilayer film and the second $\lambda/4$ multilayer film is an oxide, and a high refractive index material thereof is a semiconductor material of Ge. A material of the wavelength selection layer is identical to a material of the second thin film from the top of the first $\lambda/4$ multilayer film.

*Fig. 1*

**Description**

TECHNICAL FIELD

The present invention relates to an infrared optical filter and a manufacturing method thereof.

BACKGROUND ART

It has been known an optical filter composed of a dielectric multilayer film in which two kinds of dielectric thin films having dissimilar refractive indices from each other but an identical optical film thickness (optical thickness of film) are alternately stacked. Examples of materials of the dielectric films include, for instance, $TiO_2$, $SiO_2$, $Ta_2O_5$, $Nb_2O_5$, $Al_2O_3$, $Si_3N_4$, $ZrO_2$, $MgF_2$, $CaF_2$ and the like.

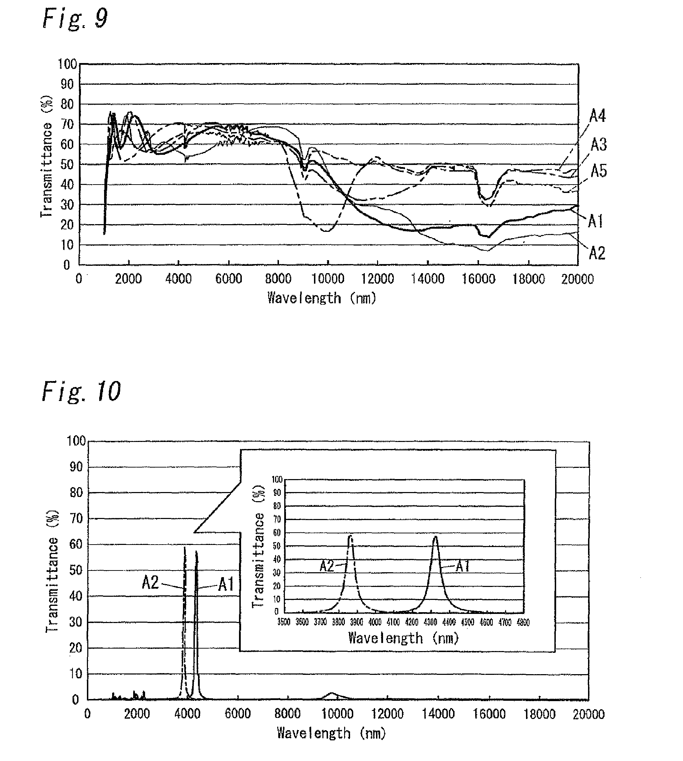

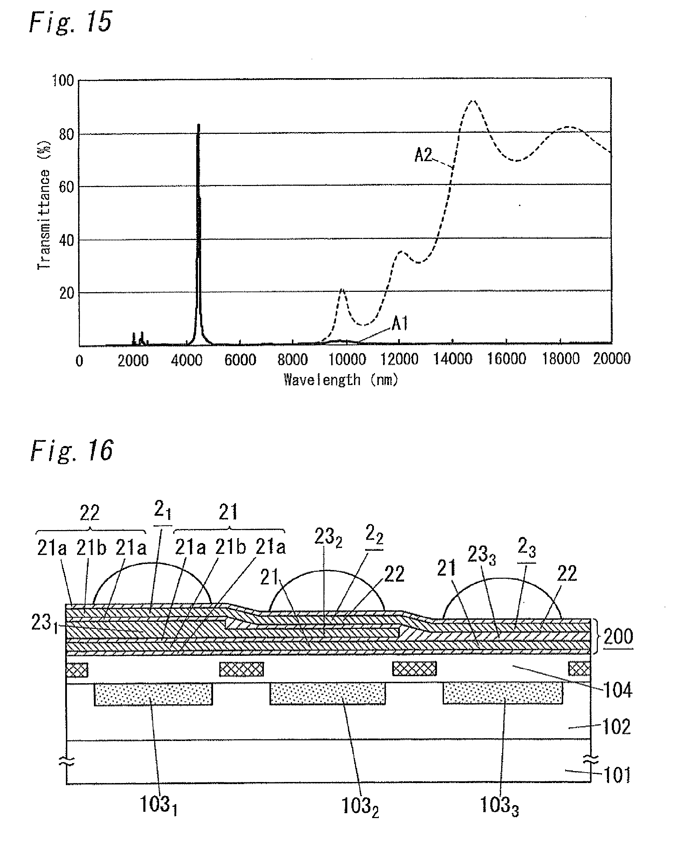

There has been proposed a solid-state imaging device provided with an optical filter **200** that has a plurality of kinds of filter parts $\mathbf{2_1}$, $\mathbf{2_2}$, $\mathbf{2_3}$ each of which is configured to selectively transmit incident light (for instance, WO 2005/069376: referred to as Patent document 1), as illustrated in Fig. 9. In a solid-state imaging device having the configuration illustrated in Fig. 16, in a p-type semiconductor layer **102** formed at one surface side of a n-type semiconductor substrate **101,** light-receiving elements $\mathbf{103_1}$, $\mathbf{103_2}$, $\mathbf{103_3}$ are formed at portions that correspond respectively to the filter parts $\mathbf{2_1}$, $\mathbf{2_2}$, $\mathbf{2_3}$. The filter parts $\mathbf{2_1}$, $\mathbf{2_2}$, $\mathbf{2_3}$ of the optical filter **200** have mutually dissimilar selection wavelengths. The filter parts $\mathbf{2_1}$, $\mathbf{2_2}$, $\mathbf{2_3}$ are formed on the side of respective light-receiving faces of the light-receiving elements $\mathbf{103_1}$, $\mathbf{103_2}$, $\mathbf{103_3}$ (top face side in Fig. 16), via an optically transparent insulating layer **104.**

The filter parts $\mathbf{2_1}$, $\mathbf{2_2}$, $\mathbf{2_3}$ of the above-described optical filter **200** comprise: a first $\lambda/4$ multilayer film **21;** a second $\lambda/4$ multilayer film **22;** and a wavelength selection layer $\mathbf{23_1}$, $\mathbf{23_2}$, $\mathbf{23_3}$, respectively. In the first $\lambda/4$ multilayer film **21,** two kinds of thin films **21a, 21b** having identical optical film thickness but formed of dielectric materials having mutually dissimilar refractive indices are alternately stacked. The second $\lambda/4$ multilayer film **22** is formed on the opposite side of the first $\lambda/4$ multilayer film **21** from the n-type semiconductor substrate **101** side. In the second $\lambda/4$ multilayer film **22,** the two kinds of thin films **21a, 21b** are alternately stacked. Each the wavelength selection layer $\mathbf{23_1}$, $\mathbf{23_2}$, $\mathbf{23_3}$ is interposed between the first $\lambda/4$ multilayer film **21** and the second $\lambda/4$ multilayer film **22,** and that has an optical film thickness different from the optical film thickness of the thin films **21a, 21b** according to a desired selection wavelength. As regards the materials of the two kinds of thin films **21a, 21b,** $TiO_2$ is used as a high refractive index material having a relatively high refractive index, and $SiO_2$ is used as a low refractive index material having a relatively low refractive index. In the example illustrated in Fig. 16, the thin film **21a** formed closest to the n-type semiconductor substrate **101** is formed of the high refractive index material, and the thin film **21b** on said thin film **21a** is formed of the low refractive index material. In the example illustrated in Fig. 16, thus, the topmost layers of the filter parts $\mathbf{2_1}$, $\mathbf{2_2}$, $\mathbf{2_3}$ are each a thin film **21a** formed of the high refractive index material.

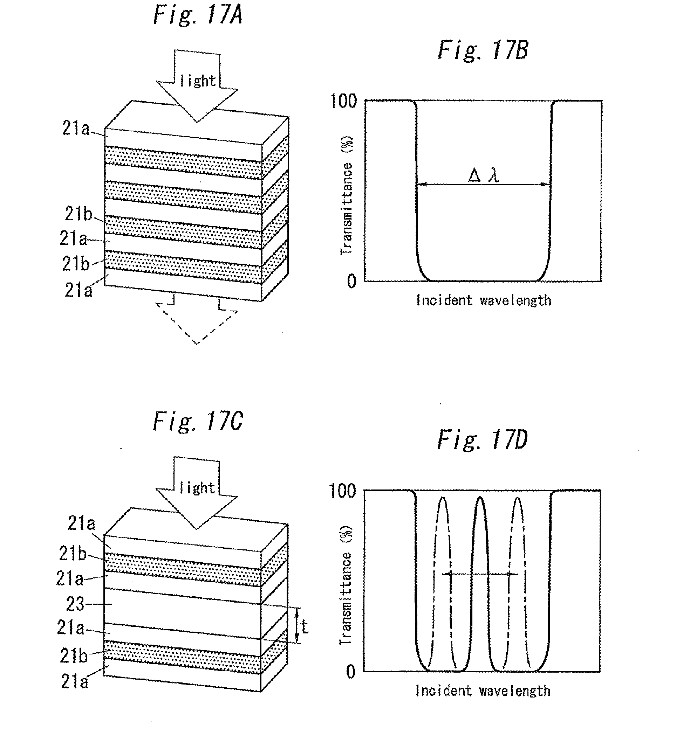

Transmission spectra of the filter parts $\mathbf{2_1}$, $\mathbf{2_2}$, $\mathbf{2_3}$ are explained next based on Fig. 17.

A stacked film (laminated film) in which the two kinds of thin films **21a, 21b** having dissimilar refractive indices are periodically stacked, as illustrated in Fig. 17A (one-dimensional photonic crystal having a periodic refractive index structure in the thickness direction alone), allows selectively reflecting only light of a specific wavelength band, as indicated by the transmission spectrum of Fig. 17B. Therefore, such stacked films are widely used for, such as, high-reflective mirrors (for instance, high-reflective mirrors for lasers) that require higher reflectance than reflective mirrors utilizing metallic films. In the configuration of Fig. 17A, reflectance and reflectance bandwidth (bandwidth of reflection band) can both be adjusted by appropriately adjusting the film thickness and the number of stack layers of the thin films **21a, 21b.** From the viewpoint of design, expanding the reflectance bandwidth is comparatively easy, but achieving transmission of only light of a specific selection wavelength is difficult.

In contrast, according to the above-described filter part $\mathbf{2_1}$, $\mathbf{2_2}$, $\mathbf{2_3}$, a wavelength selection layer **23** $\mathbf{(23_1}$, $\mathbf{23_2}$, $\mathbf{23_3)}$ having dissimilar optical film thickness is provided in the periodic refractive index structure, as illustrated in Fig. 17C, to introduce thereby some local disarray into the periodic refractive index structure. According to the configuration, a transmission band of narrower spectral width than the reflectance bandwidth can be localized in the reflection band, as shown in the transmission spectrum of Fig. 17D. Besides, the transmission peak wavelength of the transmission band can be modified by appropriately varying the optical film thickness of the wavelength selection layer **23.** Fig. 17C illustrates an example in which the wavelength selection layer **23** is formed of the same material as that of the thin film **21b,** which is formed on the opposite side of the thin film **21a** from the side on which the wavelength selection layer **23** is contacted with. The transmission peak wavelength can be modified, as indicated by the arrow in the transmission spectrum of Fig. 17D, by varying the film thickness (physical film thickness; physical thickness of film) **"t"** of the wavelength selection layer **23.**

The range over which the transmission peak wavelength can shift through modulation of the optical film thickness of the wavelength selection layer **23** depends on the reflectance bandwidth set by the first $\lambda/4$ multilayer film **21** and the second $\lambda/4$ multilayer film **22.** The wider the reflectance bandwidth is, the wider becomes the range over which the transmission peak wavelength can shift. As is known (Reference document: Mitsunobu Kobiyama, "Optical Thin-Film Filters", The Optronics Co., Ltd., p.102-106), a reflectance bandwidth $\Delta\lambda$ can be worked out approximately on the basis of Equation (1) below, in which $n_H$ denotes the refractive index of the above-described high refractive index material, $n_L$ denotes the refractive index of the low refractive index material, $\lambda_0$ denotes a set wavelength that is equivalent to four times the optical film thickness, which is common to the thin films **21a, 21b.**

[Equation 1]

$$\frac{\Delta\lambda}{\lambda_0} = \frac{4}{\pi} \cdot \sin^{-1}\left(\frac{\dfrac{n_H}{n_L} - 1}{\dfrac{n_H}{n_L} + 1}\right)$$

Equation (1) indicates that the reflectance bandwidth $\Delta\lambda$ depends on the refractive index $n_L$ of the low refractive index material and the refractive index $n_H$ of the high refractive index material, such that, in order to widen the reflectance bandwidth $\Delta\lambda$, it is important to increase the value of the refractive index ratio $n_H/n_L$, i.e. it is important to increase the refractive index difference between the high refractive index material and the low refractive index material.

The optical filter **200** in the solid-state imaging device illustrated in Fig. 16 is an example of a filter for visible light, and a combination of $TiO_2$ and $SiO_2$, which afford the greatest refractive index difference from among combinations of oxides having very high transparency and no absorption in the visible light region, is exemplified for the combination of the high refractive index material and the low refractive index material.

Various technologies are known in which gases and/or flame are sensed by using infrared ray detection elements and infrared optical filters (for instance, Japanese Patent Application Publication No. S58-58441: referred to as Patent document 2; Japanese Patent Application Publication No. 2001-228086: referred to as Patent document 3; Japanese Patent Application Publication No. H5-346994: referred to as Patent document 4).

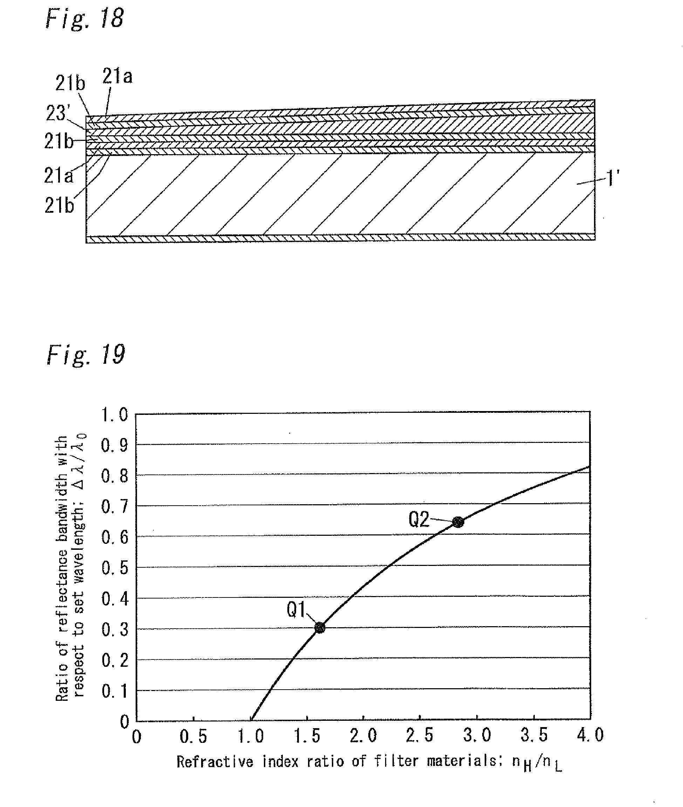

Patent document 3 proposes an infrared optical filter in the form of a multi-wavelength selection filter that transmits infrared rays of dissimilar selection wavelengths depending on an in-plane position, as shown in Fig. 18. This multi-wavelength selection filter has a stacked structure in which a thin film **21b,** formed of a low-refractive material transparent in the infrared region and a thin film **21a,** formed of a high refractive index material transparent in the infrared region, are alternately stacked. Then, a wavelength selection layer (spacer layer) **23',** formed of the high refractive index material, is provided halfway the stacked structure, such that the film thickness of the wavelength selection layer **23'** varies continuously in the in-plane direction (left-right direction in Fig. 18). In the infrared optical filter having the configuration illustrated in Fig. 18, a Si substrate is used as a substrate **1'** that underlies the abovementioned stacked structure. The film thickness of the wavelength selection layer **23'** is configured to vary continuously in the in-plane direction in such a manner that infrared rays of $4.25\mu$ m, which is the absorption wavelength of $CO_2$ as a target gas, and infrared rays of 3.8 $\mu$m, which is set as the wavelength of reference light that is not absorbed by various gases, can be transmitted at mutually dissimilar positions.

In the infrared optical filter having the configuration illustrated in Fig. 18, the wavelength selection layer **23'** is configured that the film thickness whereof varies continuously in the in-plane direction. However, achieving variation of film thickness with good reproducibility and good stability is difficult during manufacturing. Moreover, since the film thickness of the wavelength selection layer **23'** varies continuously, it is difficult to narrow the transmission band for infrared rays of a selection wavelength. Thus, they cause to degrade the filter performance. Therefore, it is difficult to increase the performance and to lower the costs, of such as gas sensors and flame sensors that utilize an infrared ray detection element.

The optical filter **200** having the configuration illustrated in Fig. 16 could be conceivably used, but herein both the high refractive index material and the low refractive index material are oxides, namely, $TiO_2$ is used as the high refractive index material and $SiO_2$ is used as the low refractive index material. Therefore, it is difficult to widen the reflectance bandwidth $\Delta\lambda$ in the infrared region (i.e. it is difficult to widen a range over which the transmission peak wavelength can be set).

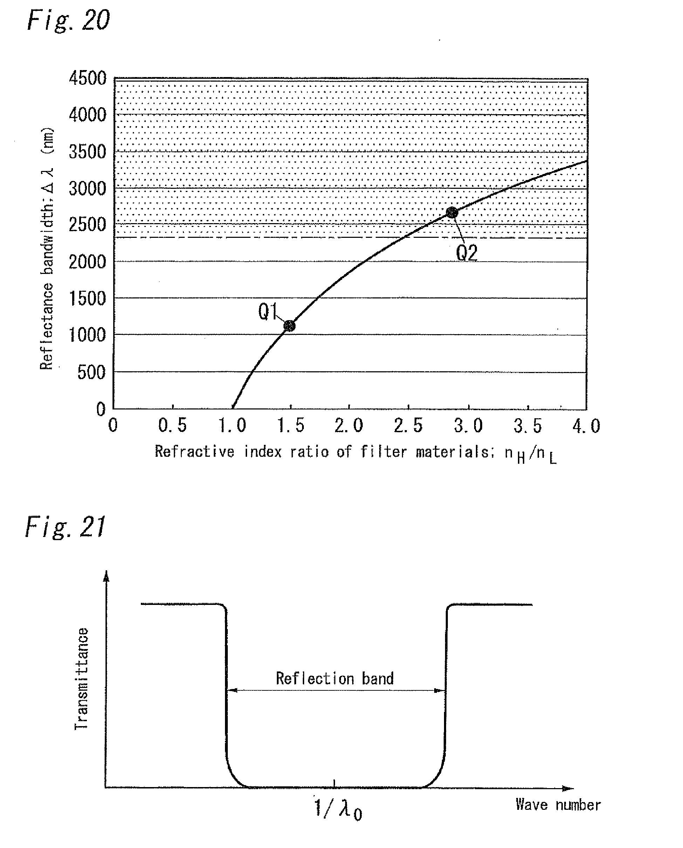

Fig. 19 and Fig. 20 illustrate results of calculations performed using the abovementioned Equation (1) concerning the relationship of reflectance bandwidth $\Delta\lambda$ with respect to the refractive index ratio $n_H/n_L$, where $n_H$ is the refractive index of the high refractive index material in the filter materials and $n_L$ is the refractive index of the low refractive index material in the filter materials. In Fig. 19 and Fig. 20, the abscissa axis represents the refractive index ratio $n_H/n_L$. The ordinate axis of Fig. 19 represents the value of the reflectance bandwidth $\Delta\lambda$ normalized with the set wavelength $\lambda_0$. The ordinate axis in Fig. 20 represents the reflectance bandwidth $\Delta\lambda$. As shown in Fig. 19 and Fig. 20, the reflectance bandwidth $\Delta\lambda$ increases with the increase of the refractive index ratio $n_H/n_L$, this is due to the increase of reflection of incident light in various wavelengths.

In a case where $TiO_2$ is used as the high refractive index material and $SiO_2$ is used as the low refractive index material, the refractive index of $TiO_2$ is 2.5 and the refractive index of $SiO_2$ is 1.5. Therefore, the refractive index ratio $n_H/n_L$ is 1.67, and the reflectance bandwidth $\Delta\lambda$ is 0.3 times the set wavelength $\lambda_0$, as indicated by point **Q1** in Fig. 19.

Specific wavelengths for detecting (sensing) various gases and flame that can occur, for instance, in houses, include 3.3 $\mu$m for $CH_4$ (methane), 4.0 $\mu$m for $SO_3$ (sulfur trioxide), 4.3 $\mu$m for $CO_2$ (carbon dioxide), 4.7 $\mu$m for CO (carbon monoxide), 5.3 $\mu$m for NO (nitrogen monoxide) and 4.3 $\mu$m for flame. Therefore, a reflection band in the infrared region of about 3.1 $\mu$m to 5.5 $\mu$m is required for selective detection of all the above-listed specific wavelengths, and thus the reflectance bandwidth $\Delta\lambda$ must be 2.4 $\mu$m or greater.

As illustrated in Fig. 21, the reflection band is symmetrical with respect to $1/\lambda_0$ in a transmission spectrum diagram where the abscissa axis represents the wave number (i.e. the reciprocal of the wavelength) of incident light and the ordinate axis represents the transmittance. Therefore, in an infrared optical filter that uses a combination of $TiO_2$ and $SiO_2$ as the combination of a high refractive index material and a low refractive index material, and assuming the set wavelength $\lambda_0$ to be 4.0 $\mu$m, which is the reciprocal of the average value of 1/3.1 ($\mu m^{-1}$) and 1/5.5 ($\mu m^{-1}$) as the respective wave numbers, then the reflectance bandwidth $\Delta\lambda$ remains at about 1.1 $\mu$m, as indicated by point **Q1** in Fig. 19, so that it is not possible to set all the above-described selection wavelengths.

In the field of infrared optical filters, combination of Ge and ZnS, both transparent in the infrared region, are ordinary adopted as the combination of a high refractive index material and a low refractive index material. However, the refractive index of Ge is 4.0 and the refractive index of ZnS is 2.3. Therefore, the refractive index ratio $n_H/n_L$ is 1.74, and the reflectance bandwidth $\Delta\lambda$ is of about 1.5 $\mu$m. In this case as well, it is not possible to set all the above-described selection wavelengths. Patent document 3 discloses the feature of using Si as the high refractive index material, but this entails a further narrower reflectance bandwidth $\Delta\lambda$.

In order to use the optical filter **200** having the configuration illustrated in Fig. 16 as an infrared optical filter, Ge and ZnS could be conceivably used as the high refractive index material as the low refractive index material, respectively. As methods for manufacturing the optical filter **200** having the configuration illustrated in Fig. 16, there have been exemplified formation methods that utilize etching or lift-off as methods for patterning the wavelength selection layers **23$_1$, 23$_2$**. However, in a case where Ge is used as the high refractive index material and ZnS is used as the low refractive index material for using such the optical filter as an infrared optical filter, both Ge and ZnS are semiconductor materials, and it is difficult to etch with high selectivity. Therefore, the film thickness (physical film thickness) and thus the optical film thickness of either the thin film **21a** or the thin film **21b**, which is exposed during the etching of the wavelength selection layers **23$_1$, 23$_2$** (from among the formed two kinds of thin films **21a, 21b),** is to be decreased. And thus, the filter performance deviates from the design performance. In a formation method that relies on lift-off technique as a pattern formation method of the wavelength selection layers **23$_1$, 23$_2$**, because the wavelength selection layers **23$_1$, 23$_2$** must be formed after formation of a resist pattern, limitations are imposed on the film formation method and the film formation conditions of the wavelength selection layers **23$_1$, 23$_2$**. It is thus difficult to achieve high-quality wavelength selection layers **23$_1$, 23$_2$**, and filter performance is impaired.

In case of using the combination of Ge and ZnS as the combination of a high refractive index material and a low refractive index material in an infrared optical filter as described above, a thin film formed of a semiconductor material of Ge or ZnS is to be exposed at the surface of the infrared optical filter. Thus, the properties of the thin film at the topmost layer may change thereupon on account of, for instance, adhesion or adsorption of impurities and/or reactions with moisture, oxygen and the like in air, all of which is deemed to impair filter performance. Therefore, in a case where the infrared optical filter is disposed for instance on the light-receiving face of an infrared ray detection element, the sensitivity and stability of infrared ray detection may be impaired at the infrared ray detection element. Besides, if the thin film at the topmost layer is formed of Ge, which is the high refractive index material, the reflective component at the surface becomes larger, and it becomes difficult to enhance filter characteristics.

## DISCLOSURE OF THE INVENTION

## PROBLEMS TO BE RESOLVED BY THE INVENTION

In the light of the above-described issues, it is an object of the present invention to provide an infrared optical filter that affords a high degree of freedom in the design of selection wavelengths and that exhibits better filter performance, and to provide a method for manufacturing that infrared optical filter.

# EP 2 397 873 A1

## MEANS OF SOLVING THE PROBLEMS

The infrared optical filter of the present invention comprises: a substrate formed of an infrared transmitting material; and a plurality of filter parts arranged side by side on one surface side of the substrate. Each filter part includes: a first λ/4 multilayer film in which two kinds of thin films having mutually different refractive indices but an identical optical film thickness are alternately stacked; a second λ/4 multilayer film in which the two kinds of thin films are alternately stacked, said second λ/4 multilayer film being formed on the opposite side of the first λ/4 multilayer film from the substrate side; and a wavelength selection layer interposed between the first λ/4 multilayer film and the second λ/4 multilayer film, said wavelength selection layer having an optical film thickness different from the optical film thickness of each the thin film according to a desired selection wavelength. A low refractive index material of the first λ/4 multilayer film and the second λ/4 multilayer film is an oxide, and a high refractive index material thereof is a semiconductor material of Ge. A material of the wavelength selection layer is identical to a material of the second top thin film of the first λ/4 multilayer film.

In this case, using an oxide as the low refractive index material and Ge of a semiconductor material as the high refractive index material in the first λ/4 multilayer film and the second λ/4 multilayer film allows increasing the refractive index difference between the high refractive index material and the low refractive index material, as compared with a case where both the high refractive index material and the low refractive index material are semiconductor materials. And thus, there can be widened the reflectance bandwidth and the selection wavelength range at which selection is enabled through setting of the film thickness of wavelength selection layer. The degree of freedom in the design of the selection wavelengths is increased as a result. The material of the wavelength selection layer is identical to the material of the second top thin film of the first λ/4 multilayer film. Therefore, the etching selectivity in a case where the wavelength selection layer is patterned through etching can be increased, and thereby a decrease of the optical film thickness of the thin film of the topmost layer of the first λ/4 multilayer film during the above-mentioned patterning can be prevented, so that filter performance can be enhanced.

In the second λ/4 multilayer film, preferably, the thin film furthest from the substrate is formed of the low refractive index material.

This allows preventing changes in the properties of the thin films that are furthest from the substrate in the filter parts, caused by for instance reactions with moisture, oxygen and the like in air or adhesion and/or adsorption of impurities. The filter performance in stability is thus improved. Besides, reflection at the surfaces of the filter parts can be reduced. The filter performance can be enhanced accordingly.

Preferably, the low refractive index material is $Al_2O_3$ or $SiO_2$.

In this case, a filter performance can be achieved such that the filter has a reflection band at an infrared region of about 3.1 μm to 5.5 μm, by setting the set wavelength of the first λ/4 multilayer film **21** and the second λ/4 multilayer film **22** to 4 μm.

Preferably, the infrared transmitting material is Si.

In this case, costs are reduced compared with a case in which the infrared transmitting material is Ge or ZnS.

An infrared optical filter manufacturing method of the present invention comprises a basic step of alternately stacking two kinds of thin films having mutually different refractive indices but an identical optical film thickness, on one surface side of the substrate. Halfway the basic step, there is performed, at least once, a wavelength selection layer formation step. The wavelength selection layer formation step includes: a wavelength selection layer film-formation step of forming a wavelength selection layer formed of a material identical to that of the second top layer of the stacked film in said halfway of the basic step, on the stacked film; and a wavelength selection layer patterning step of etching an unwanted portion, in the wavelength selection layer formed in the wavelength selection layer film-formation step, by using an uppermost layer of the stacked film as an etching stopper layer, where the unwanted portion is a portion other than a portion corresponding to one arbitrary filter part. Optical film thickness of the wavelength selection layer is set in accordance with the selection wavelength of said one arbitrary filter part from among filter parts.

In this case, there can be provided an infrared optical filter that affords a high degree of freedom in the design of selection wavelengths, and that exhibits higher filter performance stability.

## BRIEF DESCRIPTION OF THE DRAWINGS

Fig. 1 is a schematic cross-sectional diagram of an infrared optical filter according to an embodiment of the present invention;
Fig. 2 is a schematic cross-sectional diagram of a periodic refractive index structure for explaining a reflectance bandwidth of the infrared optical filter;
Fig. 3 is a transmission spectrum diagram of the periodic refractive index structure;
Fig. 4 is an explanatory diagram of the relationship between reflectance bandwidth and refractive index of a low refractive index material in the periodic refractive index structure;

Fig. 5 is a schematic cross-sectional diagram illustrating a basic configuration of a filter part in the infrared optical filter;

Fig. 6 is an explanatory diagram of characteristics of the basic configuration;

Fig. 7 is an explanatory diagram of characteristics of the basic configuration;

Fig. 8 is a set of cross-sectional diagrams of main steps, for explaining a manufacturing method of the infrared optical filter;

Fig. 9 is a transmission spectrum diagram of a thin film formed by a far infrared absorbing material in an infrared optical filter of a further invention;

Fig. 10 is a transmission spectrum diagram of the infrared optical filter;

Fig. 11 is a schematic cross-sectional diagram of an infrared optical filter in a yet further invention;

Fig. 12 is a schematic configuration diagram of an ion beam assisted deposition apparatus used in the manufacture of the infrared optical filter;

Fig. 13 is a diagram illustrating the results of an FT-IR analysis (Fourier transform infrared spectroscopy) of film quality of a thin film formed using the ion beam assisted deposition apparatus;

Fig. 14A is a transmission spectrum diagram of a reference example in which an $Al_2O_3$ film having a film thickness of 1 $\mu$m is formed on a Si substrate, and Fig. 14B is an explanatory diagram of optical parameters (refractive index and absorption coefficient) of an $Al_2O_3$ film, calculated on the basis of the transmission spectrum diagram of Fig. 14A;

Fig. 15 is a transmission spectrum diagram of the infrared optical filter;

Fig. 16 is a schematic cross-sectional diagram of a conventional solid-state imaging device;

Fig. 17A, Fig. 17B, Fig. 17C and Fig. 17D are explanatory diagrams of an optical filter;

Fig. 18 is a schematic cross-sectional diagram of a conventional infrared optical filter;

Fig. 19 is an explanatory diagram of the relationship between a refractive index ratio of filter materials and a ratio of reflectance bandwidth with respect to a set wavelength;

Fig. 20 is an explanatory diagram of the relationship between a refractive index ratio of filter materials and a reflectance bandwidth; and

Fig. 21 is an explanatory diagram of the relationship between a set wavelength and a reflection band.


BEST MODE FOR CURRYING OUT THE INVENTION

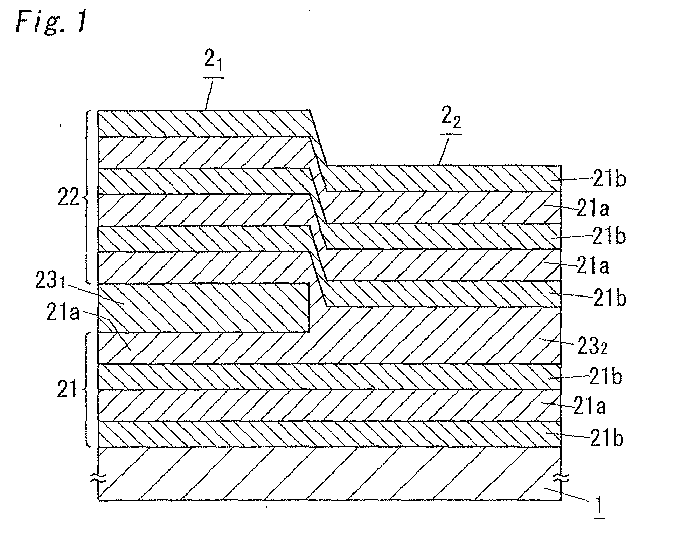

As illustrated in Fig. 1, the infrared optical filter of the present embodiment comprises: a substrate **1** made up of an infrared transmitting material; and a plurality of (herein, two) filter parts $2_1$, $2_2$ arranged side by side on one surface side of the substrate **1**. Filter part $2_1$, $2_2$ comprises: a first $\lambda/4$ multilayer film **21** in which two kinds of thin films **21b, 21a** having mutually dissimilar refractive indices and a same optical film thickness (optical thickness of film) are alternately stacked; a second $\lambda/4$ multilayer film **22,** which is formed on across the first $\lambda/4$ multilayer film **21** from the substrate **1,** and in which the two kinds of thin films **21a, 21b** are alternately stacked; and a wavelength selection layer $23_1$, $23_2$ that is interposed between the first $\lambda/4$ multilayer film **21** and the second $\lambda/4$ multilayer film **22** and that has an optical film thickness different from the optical film thickness of the thin films **21a, 21b** according to a desired selection wavelength. In the two kinds of thin films **21a, 21b,** the tolerance of the variability in the optical film thickness is of about $\pm 1\%$. The tolerance of the variability in the physical film thickness is decided in accordance with the variability in the optical film thickness.

As the infrared transmitting material of the substrate **1** there is used Si (i.e. a Si substrate is used as the substrate 1), but the infrared transmitting material is not limited to Si, and may be Ge, ZnS or the like. In the present embodiment, the plan-view shape of the filter part $2_1$, $2_2$ is a square of several millimeters, and the plan-view shape of the substrate **1** is a rectangular shape. However, the plan-view shapes and dimensions are not particularly limited to the foregoing.

In the infrared optical filter of the present embodiment, $Al_2O_3$, which is one kind of oxide, is used as the material (low refractive index material) of the thin film **21b** that is a low refractive index layer in the first $\lambda/4$ multilayer film **21** and the second $\lambda/4$ multilayer film **22**. Then, Ge, having a higher refractive index than Si, and being one kind of semiconductor material, is used as the material (high refractive index material) of the thin film **21a** that is a high refractive index layer. The materials of the wavelength selection layers $23_1$, $23_2$ are respectively identical to the materials of the thin films **21b, 21a** disposed second from the top of the first $\lambda/4$ multilayer film **21** that stands immediately below the wavelength selection layers $23_1$, $23_2$. In the second $\lambda/4$ multilayer film **22,** those thin films **21b, 21b** that are furthest from the substrate **1** are formed of the above-described low refractive index material. The low refractive index material is not limited to $Al_2O_3$, and there may be used $SiO_2$, which is one kind of oxide. Herein, $SiO_2$ has a lower refractive index than $Al_2O_3$, and hence there can be achieved a greater refractive index difference between the high refractive index material and the low refractive index material. In Fig. 19 and Fig. 20, the point **Q2** represents a simulation result in a case where Ge is used as the high refractive index material and $SiO_2$ is used as the low refractive index material.

In the present embodiment, the set wavelength $\lambda_0$ of the first $\lambda/4$ multilayer film **21** and the second $\lambda/4$ multilayer film **22** is set to 4 $\mu$m so that the above-described various gases and flame can be detected by appropriately setting the respective optical film thicknesses of the wavelength selection layers $23_1$, $23_2$. The physical film thickness of each thin film **21a, 21b** is set to $\lambda_0/4n_H$ and $\lambda_0/4n_L$, respectively, wherein $n_H$ is the refractive index of the high refractive index material and $n_L$ is the refractive index of the low refractive index material. In a concrete case where the high refractive index material is Ge and the low refractive index material is $Al_2O_3$, i. e. $n_H$=4.0 and $n_L$=1.7, the physical film thickness of the thin film **21a** formed of the high refractive index material is set to 250 nm, and the physical film thickness of the thin film **21b** formed of the low refractive index material is set to 588 nm.

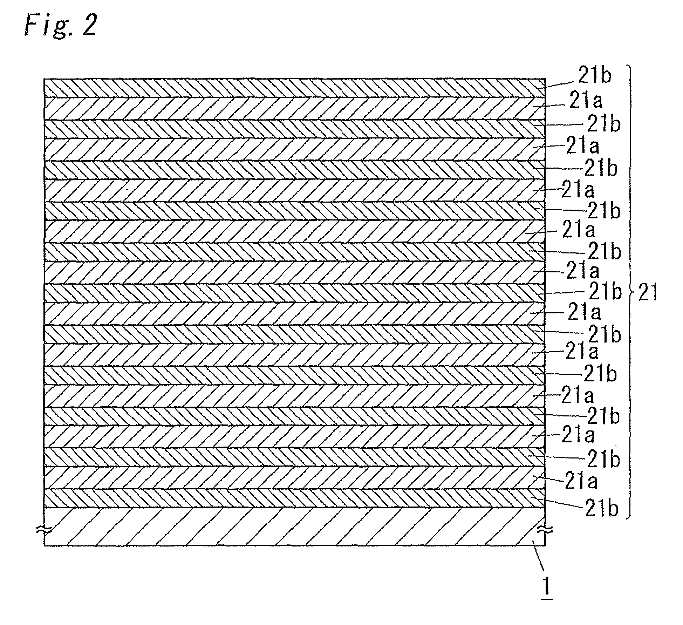

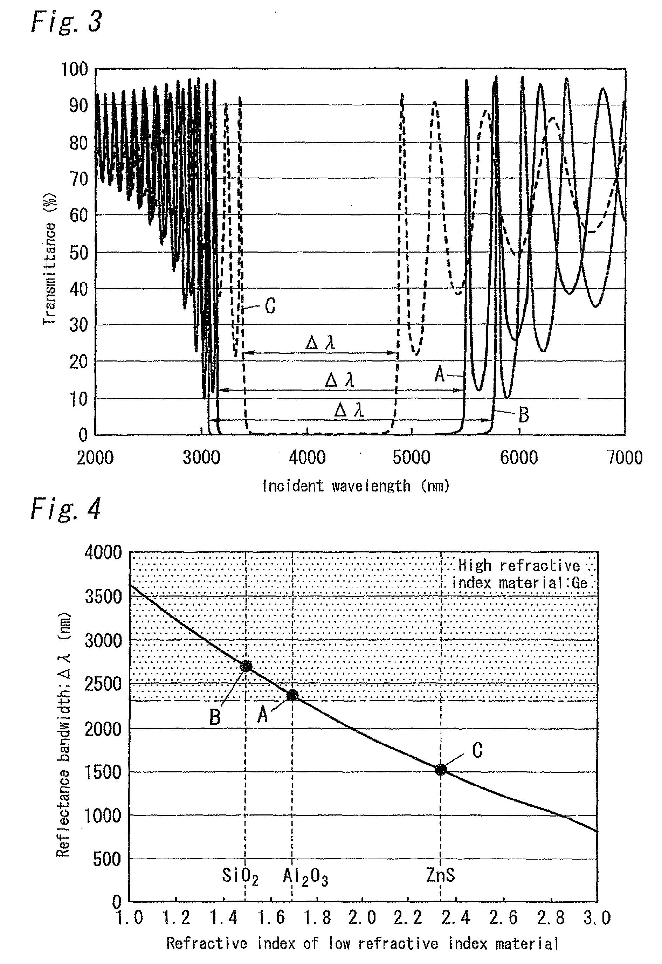

Herein, assuming that there are 21 layers in a $\lambda/4$ multilayer film resulting from alternately stacking the thin film **21b** formed of a low refractive index material and the thin film **21a** formed of a high refractive index material, on one surface side of the substrate **1** formed of a Si substrate, as illustrated in Fig. 2. Then, assuming that the set wavelength $\lambda_0$ is 4 $\mu$m, and assuming no absorption in the thin films **21a, 21b** (i.e. assuming that each thin film **21a, 21b** has an attenuation coefficient of 0). Fig. 3 illustrates a simulation result of transmission spectrums of the case.

In Fig. 3, the abscissa axis represents the wavelength of incident light (infrared rays), and the ordinate axis represents transmittance. In the figure, **"A"** represents a transmission spectrum in a case where the high refractive index material is Ge ($n_H$=4.0) and the low refractive index material is $Al_2O_3$ ($n_L$=1.7); **"B"** represents a transmission spectrum in a case where the high refractive index material is Ge ($n_H$=4.0) and the low refractive index material is $SiO_2$ ($n_L$=1.5); and "C" represents a transmission spectrum in a case where the high refractive index material is Ge ($n_H$=4.0) and the low refractive index material is ZnS ($n_L$=2.3).

Fig. 4 illustrates the results of a simulation of reflectance bandwidth $\Delta\lambda$ in a case where the high refractive index material is Ge, and there varies the refractive index of the low refractive index material. The lines **"A", "B"** and **"C"** in Fig. 3 correspond to the points **"A", "B"** and **"C"** in Fig. 4, respectively.

Fig. 3 and Fig. 4 show that the reflectance bandwidth $\Delta\lambda$ increases as the refractive index difference between the high refractive index material and the low refractive index material becomes greater. The figures indicate that, in a case where the high refractive index material is Ge, at least a reflection band of 3.1 $\mu$m to 5.5 $\mu$m in the infrared region can be secured, and a reflectance bandwidth $\Delta\lambda$ of 2.4 $\mu$m or greater can be achieved, by selecting $Al_2O_3$ or $SiO_2$ as the low refractive index material.

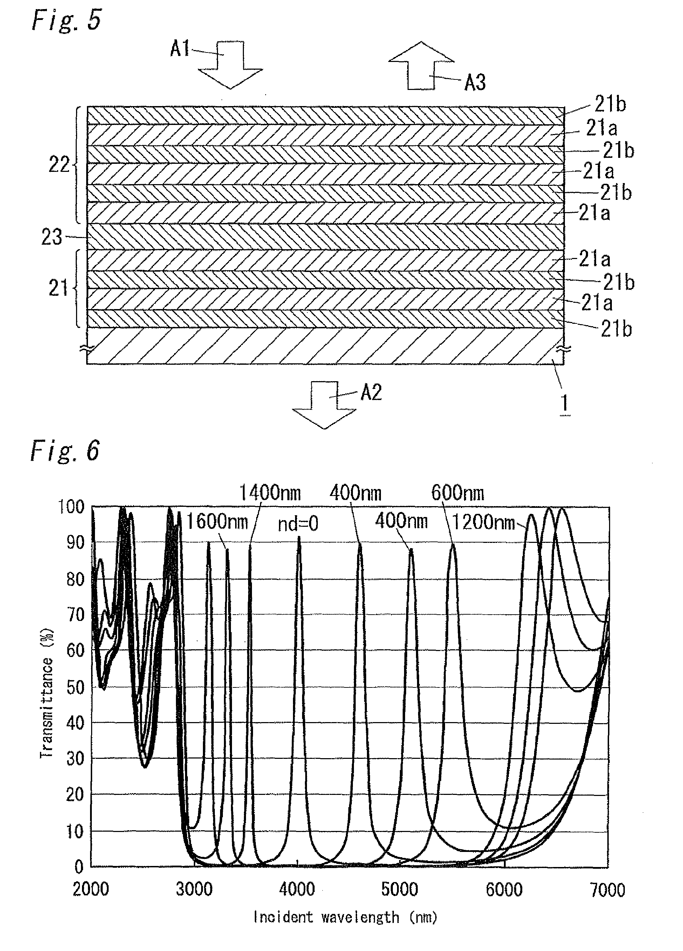

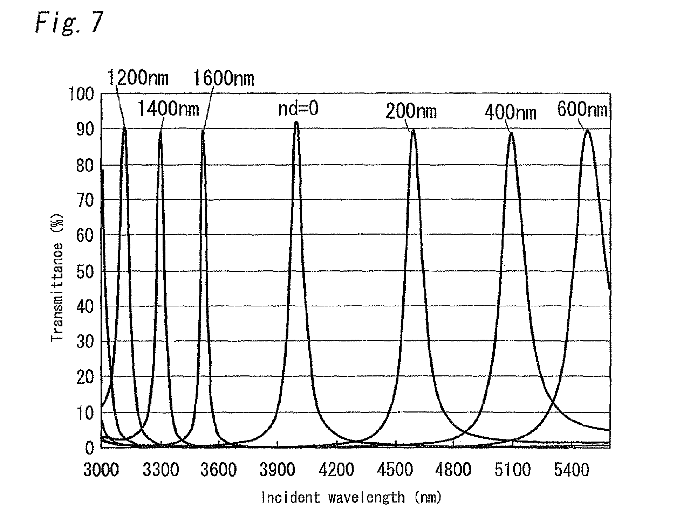

Fig. 6 and Fig. 7 illustrate the results of a simulation of a transmission spectrum, upon variation of the optical film thickness of the wavelength selection layer **23** within a range from 0 nm to 1600 nm, in a case where the number of stack layers of the first $\lambda/4$ multilayer film **21** is four, the number of stack layers of the second $\lambda/4$ multilayer film **22** is six, as illustrated in Fig. 5, the high refractive index material of the thin film **21a** is Ge, the low refractive index material of the thin film **21b** is $Al_2O_3$, and the material of the wavelength selection layer **23** interposed between the first $\lambda/4$ multilayer film **21** and the second $\lambda/4$ multilayer film **22** is $Al_2O_3$, which is the low refractive index material. In Fig. 5, arrow **"A1"** represents incident light, arrow **"A2"** represents transmitted light, and arrow **"A3"** represents reflected light. The optical film thickness of the wavelength selection layer **23** is obtained as "nd", i.e. as the product of the refractive index "n" and the physical film thickness "d", wherein "n" denotes the refractive index of the material of the wavelength selection layer **23** and "d" denotes the physical film thickness of the wavelength selection layer **23.** In the simulation, the set wavelength $\lambda_0$ was 4 $\mu$m, the physical film thickness of the thin film **21a** was 250 nm, the physical film thickness of the thin film **21b** was 588 nm, and assuming no absorption in the thin films **21a, 21b** (i.e. assuming that each thin film **21a, 21b** has an attenuation coefficient of 0).

Fig. 6 and Fig. 7 indicate that the first $\lambda/4$ multilayer film **21** and the second $\lambda/4$ multilayer film **22** form a reflection band in the 3 $\mu$m to 6 $\mu$m infrared region, and indicate that narrow transmission band can be localized in the 3 $\mu$m to 6 $\mu$m reflection band, through appropriate setting of the optical film thickness "nd" of the wavelength selection layer **23.** Specifically, the transmission peak wavelength can vary continuously within a range from 3.1 $\mu$m to 5.5 $\mu$m through variation of the optical film thickness "nd" of the wavelength selection layer **23** within a range from 0 nm to 1600 nm. More specifically, setting the optical film thickness "nd" of the wavelength selection layer 23 to 1390 nm, 0 nm, 95 nm, 235 nm and 495 nm yields 3.3 $\mu$m, 4.0 $\mu$m, 4.3 $\mu$m, 4.7 $\mu$m and 5.3 $\mu$m transmission peak wavelengths, respectively.

Accordingly, appropriately varying only the design of the optical film thickness of the wavelength selection layer **23,** without modifying the design of the first $\lambda/4$ multilayer film **21** or the second $\lambda/4$ multilayer film **22,** allows sensing various gases, for instance $CH_4$ having a specific wavelength of 3.3 $\mu$m, $SO_3$ having a specific wavelength of 4.0 $\mu$m, $CO_2$ having a specific wavelength of 4.3 $\mu$m, CO having a specific wavelength of 4.7 $\mu$m, and NO having a specific wavelength of 5.3 $\mu$m, and allows sensing a flame having a specific wavelength of 4.3 $\mu$m. An optical film thickness "nd" ranging from 0 nm to 1600 nm corresponds to a physical film thickness "d" ranging from 0 nm to 941 nm. The reason why the transmission peak wavelength is 4000 nm in a case where the optical film thickness "nd" of the wavelength selection layer **23** is 0 nm, i.e. a case where the wavelength selection layer **23** is absent in Fig. 5, is that the set wavelength $\lambda_0$ of the first $\lambda/4$ multilayer film **21** and the second $\lambda/4$ multilayer film **22** is set to 4 $\mu$m (4000 nm). The transmission peak wavelength in a case where the wavelength selection layer **23** is absent can be modified by appropriately varying the set wavelength $\lambda_0$ of the first $\lambda/4$ multilayer film **21** and the second $\lambda/4$ multilayer film **22.** The tolerance in the variability of the optical film thickness of the wavelength selection layer **23** is about $\pm$1%.

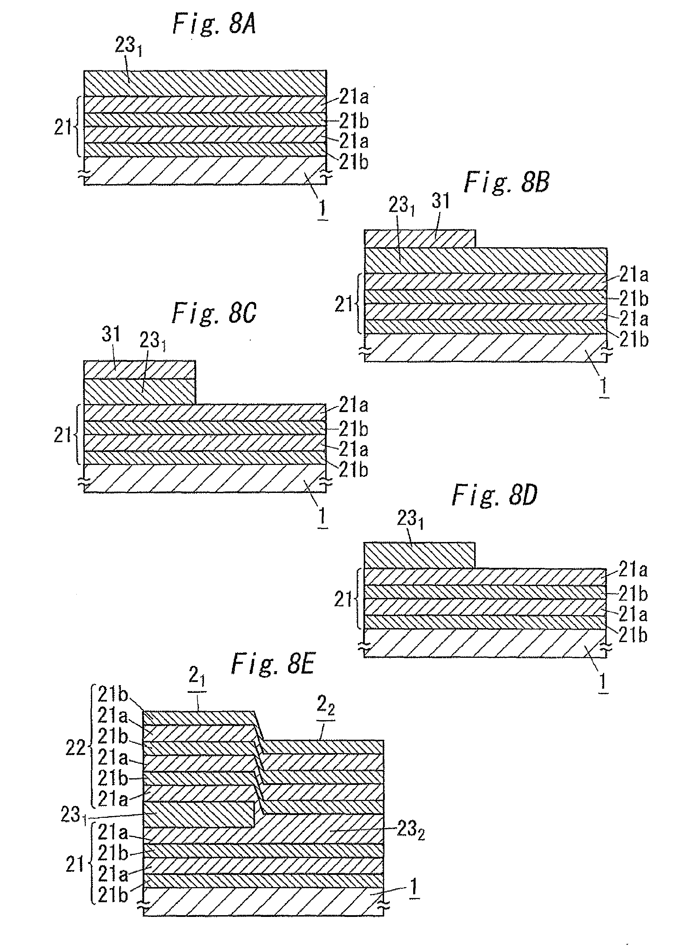

A method for manufacturing the infrared optical filter of the present embodiment will be explained next with reference to Fig. 8.

Firstly, there is carried out a "first $\lambda/4$ multilayer film-formation step" of forming a first $\lambda/4$ multilayer film 21 by alternately stacking the thin film **21b** having a predetermined physical film thickness (588 nm) formed of $Al_2O_3$ as a low refractive index material, and the thin film **21a** having a predetermined physical film thickness (250 nm) formed of Ge as a high refractive index material, on the entire surface of one surface side of the substrate **1** formed of Si as an infrared transmitting material. Next, there is carried out a "wavelength selection layer film-formation step" of forming the wavelength selection layer **23₁** on the entire surface of said one surface side of the substrate **1** (herein, on the surface of the first $\lambda/4$ multilayer film **21**), wherein the optical film thickness of the wavelength selection layer **23₁** is set in accordance with the selection wavelength of one filter part **2₁**, and the wavelength selection layer **23₁** is formed of a material (herein, $Al_2O_3$ being the low refractive index material) identical to that of the thin film **21b** positioned second from the top of the first $\lambda/4$ multilayer film **21.** Thereby, the structure illustrated in Fig. 8A is obtained. As the method for forming the thin films **21b, 21a** and the wavelength selection layer **23₁,** the two kinds of thin films **21b, 21a** can be continuously formed when using a method such as vapor deposition or sputtering. If the low refractive index material is $Al_2O_3$ as described above, however, it is preferable to use ion beam assisted deposition to irradiate an oxygen ion beam during formation of the thin film **21b** so as to increase the compactness of the thin film **21b.** $SiO_2$ may be used as the low refractive index material.

After the above-described wavelength selection layer film-formation step, there is carried out a "resist layer formation step" of forming a resist layer **31** that covers only the site corresponding to the filter part **2₁** by photolithography, to yield the structure illustrated in Fig. 8B.

Thereafter, there is carried out a "wavelength selection layer patterning step" of selectively etching an unwanted portion in the wavelength selection layer **23₁,** using the resist layer **31** as a mask, and using the topmost thin film **21a** of the first $\lambda/4$ multilayer film **21** as an etching stopper layer, to yield the structure illustrated in Fig. 8C. In the wavelength selection layer patterning step, if the low refractive index material is an oxide ($Al_2O_3$) and the high refractive index material is a semiconductor material (Ge), as described above, then etching can be performed, with higher etching selectivity than in dry etching, by adopting wet etching using a hydrofluoric acid solution as the etching solution. That is because oxides such as $Al_2O_3$ and $SiO_2$ are readily soluble in a hydrofluoric acid solution, whereas Ge is very hard to dissolve in a hydrofluoric acid solution. As an example, if wet etching is performed using a hydrofluoric acid solution in the form of dilute hydrofluoric acid composed of a mixed liquid of hydrofluoric acid (HF) and pure water ($H_2O$) (for instance, dilute hydrofluoric acid having a concentration of hydrofluoric acid of 2%), then the etching rate of $Al_2O_3$ is about 300 nm/min, and etching can be carried out with high etching selectivity, in that the etching-rate ratio between $Al_2O_3$ and Ge of about 500:1.

After the above-described wavelength selection layer patterning step, there is performed a "resist layer removal step" of removing the resist layer **31,** to yield the structure illustrated in Fig. 8D.

After the above-described resist layer removal step, there is carried out a "second $\lambda/4$ multilayer film-formation step" of forming the second $\lambda/4$ multilayer film **22** by alternately stacking the thin film **21a** having a predetermined physical film thickness (250 nm) formed of Ge as a high refractive index material, and the thin film **21b** having a predetermined physical film thickness (588 nm) formed of $Al_2O_3$ as a low refractive index material, on the entire surface of the one surface side of the substrate **1,** to yield the infrared optical filter having the structure illustrated in Fig. 8E. As a result of the second $\lambda/4$ multilayer film-formation step, at a region corresponding to the filter part **2₂,** the thin film **21a** of the lowermost layer of the second $\lambda/4$ multilayer film **22** is stacked directly on the thin film **21a** of the topmost layer of the first $\lambda/4$ multilayer film **21**. As a result, the wavelength selection layer **23₂** of the filter part **2₂** is made up of said topmost-layer thin film **21a** and said lowermost-layer thin film **21a.** The transmission spectrum of the filter part **2₂** corresponds to a case in which the optical film thickness "nd" is 0 nm in the simulation result of Fig. 7. As the film formation method of the thin films **21a, 21b,** the two kinds of thin films **21a, 21b** can be continuously formed, when, for instance, vapor deposition, sputtering or the like is used. If the low refractive index material is $Al_2O_3$ as described above, however, it is preferable to use ion beam assisted deposition to irradiate an oxygen ion beam during formation of the thin film **21b** so as to increase the compactness of the thin film **21b.** $SiO_2$ may be used as the low refractive index material.

In summary, the manufacturing method of the infrared optical filter of the present embodiment involves performing once a wavelength selection layer formation step in halfway during a basic step, where the basic step is composed of alternately stacking the two kinds of thin films **21b, 21a** having mutually different refractive indices but an identical optical film thickness, on the one surface side of the substrate **1.** Herein, the wavelength selection layer formation step is composed of: a wavelength selection layer film-formation step of forming, on the stacked film (herein, first $\lambda/4$ multilayer film **21)** at the halfway of the basic step, a wavelength selection layer **23ᵢ** (herein, i=1) formed of a material identical to that of the second layer from the top of the abovementioned stacked film, wherein the optical film thickness of the wavelength selection layer **23ᵢ** is set in accordance with the selection wavelength of one arbitrary filter part **2ᵢ** (herein, i=l) from among a plurality of filter parts **2₁,..., 2ₘ** (herein, m=2); and a wavelength selection layer patterning step of etching an unwanted portion in the wavelength selection layer **23** formed in the wavelength selection layer film-formation step, where the unwanted portion is a portion other than a portion corresponding to the abovementioned arbitrary one

filter part $2_i$ by using an uppermost layer of the abovementioned stacked film as an etching stopper layer. Thereby, a plurality of filter parts $2_1, 2_2$ is formed. Thus, an infrared optical filter having more selection wavelengths can be produced by performing more than once the wavelength selection layer formation step halfway during the above-described basic step. An infrared optical filter that senses all the above-described gases can thus be realized in one chip.

In the above-described infrared optical filter of the present embodiment, the low refractive index material in the first $\lambda/4$ multilayer film **21** and the second $\lambda/4$ multilayer film **22** is an oxide, while the high refractive index material is a semiconductor material of Ge. As a result, the refractive index difference between the high refractive index material and the low refractive index material can be increased as compared with a case in which both the high refractive index material and the low refractive index material are semiconductor materials. The reflectance bandwidth $\Delta\lambda$ can be widened accordingly, and there can be expanded the range in which selection wavelengths can be set by selecting the film thickness of the wavelength selection layers $23_1, 23_2$. The degree of freedom in the design of the selection wavelength can be increased as a result. In the infrared optical filter of the present embodiment, the materials of the wavelength selection layers $23_1, 23_2$ are identical to the materials of the thin films **21b, 21a** that are second from the top of the first $\lambda/4$ multilayer film **21.** This allows, therefore, increasing the etching selectivity in a case where the wavelength selection layer $23_1$ is patterned through etching, and preventing a decrease of the optical film thickness of the thin film **21a** of the topmost layer (see Fig. 8C) of the first $\lambda/4$ multilayer film **21** during the above-mentioned patterning. Filter performance is enhanced thereby. Besides, in the second $\lambda/4$ multilayer film **22,** those thin films **21b, 21b** that are furthest from the substrate **1** are formed of the above-described low refractive index material. This allows preventing changes in the properties of the thin films that are furthest from the substrate **1** in the filter parts $2_1, 2_2,$ arisen from, for instance, reactions with moisture, oxygen and the like in air, or adhesion and/or adsorption of impurities. The stability of filter performance is thus improved. In addition, reflection at the surfaces of the filter parts $2_1, 2_2$ can be reduced, thus the filter performance can be enhanced.

In the infrared optical filter of the present embodiment Ge is used as the high refractive index material, and $Al_2O_3$ or $SiO_2$ is used as the low refractive index material. Therefore, a filter performance can be achieved such that the filter has a reflection band at an infrared region of about 3.1 $\mu$m to 5.5 $\mu$m, by setting to 4 $\mu$m the set wavelength of the first $\lambda/4$ multilayer film **21** and the second $\lambda/4$ multilayer film **22.**

In the infrared optical filter of the present embodiment, the infrared transmitting material of the substrate **1** is Si. Therefore, costs can be reduced compared with a case in which the infrared transmitting material is Ge or ZnS.

A further invention is explained next.

(Background of Invention)

Japanese Patent Application Publication No. 2006-39736 (referred to as Patent document 5) and Japanese Patent Application Publication No. 2003-227751 (referred to as Patent document 6) disclose the feature of using a combination of a narrow-band bandpass filter and a light blocking filter, wherein the bandpass filter is formed using a Si substrate or the like and configured to transmit infrared rays of a desired wavelength, and the light blocking filter is formed using a sapphire substrate and configured to block far infrared rays. In this constitution, far infrared rays in ambient light such as solar light or illumination light can be blocked by providing such a light blocking filter.

To block far infrared rays in an infrared optical filter having the configuration illustrated in Fig. 18, meanwhile, there must be provided, separately from the abovementioned optical filter **200,** a light blocking filter formed of a sapphire substrate for blocking far infrared rays as is the case in Patent documents 5, 6 above. This drives up costs. In an infrared optical filter having the configuration illustrated in Fig. 18, the wavelength selection layer **23'** is configured that the film thickness of which varies continuously in the in-plane direction. However, causing film thickness to vary with good reproducibility and good stability during manufacturing is difficult. It is likewise difficult to narrow the transmission band for infrared rays of the selection wavelength, since the film thickness of the wavelength selection layer **23'** varies continuously. This is a cause of filter performance impairment, and hence it is difficult to increase the performance and lower the costs of gas sensors, flame sensors and the like that utilize an infrared ray detection element.

In order to use the optical filter **200** having the configuration illustrated in Fig. 16 as an infrared optical filter, Ge could be conceivably used as a high refractive index material and ZnS as a low refractive index material. To block far infrared rays in this case as well, however, there must be provided a light blocking filter formed of a sapphire substrate for blocking far infrared rays, separately from the optical filter **200,** as is the case in Patent documents 5, 6 above. This drives up costs.

Then, in a case where Ge is used as the high refractive index material and ZnS is used as the low refractive index material in order to use the optical filter **200** having the configuration illustrated in Fig. 16 as an infrared optical filter, required number of stack layers of the thin films **21a, 21b** (that results from adding the number of the thin films of the first $\lambda/4$ multilayer film **21** and that of the second $\lambda/4$ multilayer film **22)** is of 70 or more layers for bringing out far infrared ray blocking performance without employing a light blocking filter of a sapphire substrate. This drives up costs, and may give rise to cracking of the filter parts $2_1, 2_2, 2_3.$

(Problem) to be Solved by the Invention)

In the light of the above, it is an object of the present invention to provide a low-cost infrared optical filter having infrared ray blocking performance over a wide band, from the near infrared to the far infrared, and that enables selective transmission of infrared rays of a desired selection wavelength, and to provide a method for manufacturing such a infrared optical filter.

(Means for Solving the Problem)

An infrared optical filter of the present invention is an infrared optical filter that controls infrared rays in a wavelength range from 800 nm to 20000 nm, comprising: a substrate; and a filter part that is formed on one surface side of the substrate and is configured to selectively transmit infrared rays of a desired selection wavelength. The filter part comprises: a first $\lambda/4$ multilayer film in which a plurality of kinds of thin films having mutually different refractive indices but an identical optical film thickness are stacked; a second $\lambda/4$ multilayer film in which the plurality of kinds of thin films are stacked, said second $\lambda/4$ multilayer film being formed on the opposite side of the first $\lambda/4$ multilayer film from the substrate side; and a wavelength selection layer interposed between the first $\lambda/4$ multilayer film and the second $\lambda/4$ multilayer film, said wavelength selection layer having an optical film thickness different from the optical film thickness of each the thin film according to a desired selection wavelength. At least one kind of thin film from among the plurality of kinds of thin films is formed of a far infrared absorbing material that absorbs far infrared rays of a longer wavelength range than an infrared ray reflection band set by the first $\lambda/4$ multilayer film and the second $\lambda/4$ multilayer film.

In this case, infrared ray blocking performance over a wide band, from the near infrared to the far infrared, can be realized at a low cost, thanks to the light interference effect of the first $\lambda/4$ multilayer film and the second $\lambda/4$ multilayer film, and by virtue of the far infrared ray absorption effect of the thin film included in the first $\lambda/4$ multilayer film and the second $\lambda/4$ multilayer film. As a result, there can be realized a low-cost infrared optical filter which has infrared ray blocking performance over a wide band, from the near infrared to the far infrared, and in which infrared rays of a desired selection wavelength can be selectively transmitted.

Preferably, the far infrared absorbing material is an oxide or a nitride.

In this case, it becomes possible to prevent changes in optical characteristics, caused by oxidation, of the thin film formed of the far infrared absorbing material, from among the plurality of kinds of thin films. Besides, it becomes possible to form the thin film of the far infrared absorbing material in accordance with an ordinary thin film formation method, such as vapor deposition or sputtering. Costs are thus lower.

Using $Al_2O_3$ as the far infrared absorbing material allows increasing the far infrared absorption ability as compared with a case in which $SiO_x$ or $SiN_x$ is used as the far infrared absorbing material.

Using $Ta_2O_5$ as the far infrared absorbing material allows increasing the far infrared absorption ability as compared with a case in which $SiO_x$ or $SiN_x$ is used as the far infrared absorbing material.

Using $SiN_x$ as the far infrared absorbing material allows increasing the moisture resistance of the thin film that is formed of the far infrared absorbing material.

Using $SiO_x$ as the far infrared absorbing material allows increasing the refractive index difference in the first $\lambda/4$ multilayer film and the second $\lambda/4$ multilayer film, and reducing the number of stack layers in the first $\lambda/4$ multilayer film and the second $\lambda/4$ multilayer film.

The first $\lambda/4$ multilayer film and the second $\lambda/4$ multilayer film, preferably, are formed by alternately stacking the thin film formed of Ge, where Ge is a material having a higher refractive index than the far infrared absorbing material, and the thin film formed of the far infrared absorbing material.

In this case, the refractive index difference between the high refractive index material and the low refractive index material in the first $\lambda/4$ multilayer film and the second $\lambda/4$ multilayer film can be increased, and also the number of stack layers in the first $\lambda/4$ multilayer film and the second $\lambda/4$ multilayer film can be reduced, as compared with a case in which ZnS is used as the high refractive index material.

The first $\lambda/4$ multilayer film and the second $\lambda/4$ multilayer film, preferably, are formed by alternately stacking the thin film formed of Si, where Si is a material having a higher refractive index than the far infrared absorbing material, and the thin film formed of the far infrared absorbing material.

In this case, the refractive index difference between the high refractive index material and the low refractive index material in the first $\lambda/4$ multilayer film and the second $\lambda/4$ multilayer film can be increased, and also the number of stack layers in the first $\lambda/4$ multilayer film and the second $\lambda/4$ multilayer film can be reduced, as compared with a case in which ZnS is used as the high refractive index material.

Preferably, the substrate is a Si substrate.

In this case, costs can be lowered compared with a case in which there is used a Ge substrate, a ZnS substrate, a sapphire substrate or the like as the substrate.

Preferably, the infrared optical filter comprises a plurality of the filter parts, and the optical film thickness of the wavelength selection layer of the plurality of the filter parts is different from each other.

In this case, infrared rays of a plurality of selection wavelengths can be selectively transmitted.

An infrared sensor manufacturing method of the present invention is a method for manufacturing the infrared optical filter that is provided with a plurality of the filter parts such that the optical film thickness of the wavelength selection layer is different from each filter part, wherein the method comprises a step of forming, halfway a basic step of stacking the plurality of kinds of thin films on one surface side of a substrate, at least one pattern of the wavelength selection layer. Said pattern of the wavelength selection layer is formed by: forming a thin film which is a thin film formed of a material identical to that of the second top layer of the stacked film in said halfway of the basic step and having an optical film thickness set in accordance with a selection wavelength of the one arbitrary filter part from among filter parts, on the stacked film; and etching a portion, in the thin film formed on the stacked film, other than a portion corresponding to said one arbitrary filter part.

In this case, there can be provided a low-cost infrared optical filter which has infrared ray blocking performance over a wide band, from the near infrared to the far infrared, and in which infrared rays of a plurality of desired selection wavelengths can be selectively transmitted.

An infrared sensor manufacturing method of the present invention is a method for manufacturing the infrared optical filter that is provided with a plurality of the filter parts such that the optical film thickness of the wavelength selection layer is different from each filter part, the wavelength selection layer having mutually different optical film thicknesses at respective sites corresponding to each filter part is formed through mask vapor deposition, between the first $\lambda/4$ multilayer film-formation step of forming the first $\lambda/4$ multilayer film on the one surface side of the substrate, and the second $\lambda/4$ multilayer film-formation step of forming the second $\lambda/4$ multilayer film on the opposite side of the first $\lambda/4$ multilayer film from the substrate side.

In this case, there can be provided a low-cost infrared optical filter which has infrared ray blocking performance over a wide band, from the near infrared to the far infrared, and in which infrared rays of a plurality of desired selection wavelengths can be selectively transmitted.

(Aspects of the Invention)

An infrared optical filter of the present aspect is an infrared optical filter for controlling infrared rays in a wavelength range from 800 nm to 20000 nm. As illustrated in Fig. 1, the infrared optical filter of the present aspect is provided with a substrate **1,** and a plurality (herein, two) of filter parts **2$_1$, 2$_2$** that are arranged side by side on one surface side of the substrate **1.** Each filter part **2$_1$, 2$_2$** comprises: a first $\lambda/4$ multilayer film **21** in which there is stacked a plurality of kinds (herein, two kinds) of thin films **21b, 21a** having dissimilar refractive indices but an identical optical film thickness; a second $\lambda/4$ multilayer film **22** which is formed over the first $\lambda/4$ multilayer film **21,** on the reverse side of the side of the substrate **1,** and in which the abovementioned plurality of kinds of thin films **21a, 21b** are stacked; and a wavelength selection layer **23$_1$, 23$_2$** that is interposed between the first $\lambda/4$ multilayer film **21** and the second $\lambda/4$ multilayer film **22** and that has an optical film thickness different from the optical film thickness of the thin films **21a, 21b** according to a desired selection wavelength.

As the material of the **substrate 1** there is used Si, which is an infrared transmitting material (i.e. a Si substrate is used as the substrate **1**), but the infrared transmitting material is not limited to Si, and may be, for instance, Ge, ZnS or the like. In the present aspect, the plan-view shape of the filter parts **2$_1$, 2$_2$** is a square of several millimeters, and the plan-view shape of the substrate **1** is a rectangular shape. However, the plan-view shapes and dimensions are not particularly limited to the foregoing.

In the infrared optical filter of the present aspect, $Al_2O_3$, which is one kind of far infrared absorbing material that absorbs far infrared rays, is used as the material (low refractive index material) of the thin film **21b** that is the low refractive index layer in the first $\lambda/4$ multilayer film **21** and the second $\lambda/4$ multilayer film **22,** while Ge is used as the material (high refractive index material) of the thin film **21a** that is the high refractive index layer. The materials of the wavelength selection layers **23$_1$, 23$_2$** are respectively identical to the materials of the thin films **21b, 21a** disposed second from the top of the first $\lambda/4$ multilayer film **21** that stands immediately below the wavelength selection layers **23$_1$, 23$_2$.** In the second $\lambda/4$ multilayer film **22,** those thin films **21b, 21b** that are furthest from the substrate **1** are formed of the above-described low refractive index material. The far infrared absorbing material is not limited to $Al_2O_3$, and may be, for instance, $SiO_2$ or $Ta_2O_5$, which is an oxide other than $Al_2O_3$. Herein, $SiO_2$ has a lower refractive index than $Al_2O_3$, and hence there can be achieved a greater refractive index difference between the high refractive index material and the low refractive index material.

Specific wavelengths for detecting (sensing) various gases and flame that can occur, for instance, in houses, include 3.3 $\mu$m for $CH_4$ (methane), 4.0 $\mu$m for $SO_3$ (sulfur trioxide), 4.3 $\mu$m for $CO_2$ (carbon dioxide), 4.7 $\mu$m for CO (carbon monoxide), 5.3 $\mu$m for NO (nitrogen monoxide) and 4.3 $\mu$m for flame. A reflection band in the infrared region of about 3.1 $\mu$m to 5.5 $\mu$m is required, and thus the reflectance bandwidth $\Delta\lambda$ must be 2.4 $\mu$m or greater, for selective detection of all the above-listed specific wavelengths.

In the present aspect, the set wavelength $\lambda_0$ of the first $\lambda/4$ multilayer film **21** and the second $\lambda/4$ multilayer film **22** is set to 4.0 $\mu$m, through appropriate setting of the respective optical film thicknesses of the wavelength selection layers **23$_1$, 23$_2$,** in such a way so as to enable detection of the above-described various gases and flame. The physical film thickness of each thin film **21a, 21b** is set to $\lambda_0/4n_H$ and $\lambda_0/4n_L$, respectively, wherein $n_H$ is the refractive index of the high refractive index material, i.e. the material of the thin film **21a,** and $n_L$ is the refractive index of the low refractive index material, i.e. the material of the thin film **21b.** In a concrete case where the high refractive index material is Ge and the low refractive index material is $Al_2O_3$, i.e. $n_H$=4.0 and $n_L$=1.7, the physical film thickness of the thin film **21a** formed of the high refractive index material is set to 250 nm, and the physical film thickness of the thin film **21b** formed of the low refractive index material is set to 588 nm.

Here, Fig. 3 illustrates a simulation result of transmission spectrums in a case where there are 21 layers in a $\lambda/4$ multilayer film resulting from alternately stacking the thin film **21b** formed of a low refractive index material and the thin film **21a** formed of a high refractive index material, on one surface side of the substrate **1** which is made up of a Si substrate, and the set wavelength $\lambda_0$ is 4 $\mu$m, assuming no absorption in the thin films **21a, 21b** (i.e. assuming that each thin film **21a, 21b** has an attenuation coefficient of 0).

In Fig. 3, the abscissa axis represents the wavelength of incident light (infrared rays), and the ordinate axis represents transmittance. In the figure, **"A"** represents a transmission spectrum in a case where the high refractive index material is Ge ($n_H$=4.0) and the low refractive index material is $Al_2O_3$ ($n_L$=1.7); **"B"** represents a transmission spectrum in a case where the high refractive index material is Ge ($n_H$=4.0) and the low refractive index material is $SiO_2$ ($n_L$=1.5); and "C" represents a transmission spectrum in a case where the high refractive index material is Ge ($n_H$=4.0) and the low refractive index material is ZnS ($n_L$=2.3).

Fig. 4 illustrates the results of a simulation of reflectance bandwidth $\Delta\lambda$ in a case where the high refractive index material is Ge, and there varies the refractive index of the low refractive index material. The lines **"A", "B"** and **"C"** in Fig. 3 correspond to the points **"A", "B"** and **"C"** in Fig. 4, respectively.

Fig. 3 and Fig. 4 show that the reflectance bandwidth $\Delta\lambda$ increases as the refractive index difference between the high refractive index material and the low refractive index material becomes greater. The figures indicate that, in a case where the high refractive index material is Ge, a reflection band of at least 3.1 $\mu$m to 5.5 $\mu$m in the infrared region can be secured while a reflectance bandwidth $\Delta\lambda$ of 2.4 $\mu$m or greater can be achieved, by selecting $Al_2O_3$ or $SiO_2$ as the low refractive index material.

Fig. 6 and Fig. 7 illustrate the results of a simulation of a transmission spectrum, upon variation of the optical film thickness of the wavelength selection layer **23** within a range from 0 nm to 1600 nm, in a case where the number of stack layers of the first $\lambda/4$ multilayer film **21** is four, the number of stack layers of the second $\lambda/4$ multilayer film **22** is six, the high refractive index material of the thin film **21a** is Ge, the low refractive index material of the thin film **21b** is $Al_2O_3$, as illustrated in Fig. 5, and the material of the wavelength selection layer **23** interposed between the first $\lambda/4$ multilayer film **21** and the second $\lambda/4$ multilayer film **22** is $Al_2O_3$, which is the low refractive index material. In Fig. 5, arrow **"A1"** represents incident light, arrow **"A2"** represents transmitted light, and arrow **"A3"** represents reflected light. The optical film thickness of the wavelength selection layer **23** is obtained as "nd", i.e. as the product of the refractive index "n" and the physical film thickness "d", wherein "n" denotes the refractive index of the material of the wavelength selection layer **23** and "d" denotes the physical film thickness of the wavelength selection layer **23.** In the simulation, the set wavelength $\lambda_0$ was 4 $\mu$m, the physical film thickness of the thin film **21a** was 250 nm, the physical film thickness of the thin film **21b** was 588 nm, and assuming no absorption in the thin films **21a, 21b** (i.e. assuming that each thin film **21a, 21b** has an attenuation coefficient of 0).

Fig. 6 and Fig. 7 indicate that the first $\lambda/4$ multilayer film **21** and the second $\lambda/4$ multilayer film **22** form a reflection band in the 3 $\mu$m to 6 $\mu$m infrared region, and indicate that narrow transmission bands become localized in the 3 $\mu$m to 6 $\mu$m reflection band, through appropriate setting of the optical film thickness "nd" of the wavelength selection layer **23.** Specifically, the transmission peak wavelength can vary continuously within a range from 3.1 $\mu$m to 5.5 $\mu$m through variation of the optical film thickness "nd" of the wavelength selection layer **23** within a range from 0 nm to 1600 nm. More specifically, setting the optical film thickness "nd" of the wavelength selection layer **23** to 1390 nm, 0 nm, 95 nm, 235 nm and 495 nm yields 3.3 $\mu$m, 4.0 $\mu$m, 4.3 $\mu$m, 4.7 $\mu$m and 5.3 $\mu$m transmission peak wavelengths, respectively.

Accordingly, appropriately varying only the design of the optical film thickness of the wavelength selection layer **23,** without modifying the design of the first $\lambda/4$ multilayer film **21** or the second $\lambda/4$ multilayer film **22,** allows sensing various gases, for instance $CH_4$ having a specific wavelength of 3.3 $\mu$m, $SO_3$ having a specific wavelength of 4.0 $\mu$m, $CO_2$ having a specific wavelength of 4.3 $\mu$m, CO having a specific wavelength of 4.7 $\mu$m, and NO having a specific wavelength of 5.3 $\mu$m, and allows sensing a flame having a specific wavelength of 4.3 $\mu$m. An optical film thickness "nd" ranging from 0 nm to 1600 nm corresponds to a physical film thickness "d" ranging from 0 nm to 941 nm. The reason why the transmission peak wavelength is 4000 nm in a case where the optical film thickness "nd" of the wavelength selection layer **23** is 0 nm, i.e. a case where the wavelength selection layer **23** is absent in Fig. 6, is that the set wavelength $\lambda_0$ of the first $\lambda/4$ multilayer film **21** and the second $\lambda/4$ multilayer film **22** is set to 4 $\mu$m (4000 nm). The transmission peak wavelength in a case where the wavelength selection layer **23** is absent can be modified by appropriately varying

the set wavelength $\lambda_0$ of the first $\lambda/4$ multilayer film **21** and the second $\lambda/4$ multilayer film **22.**

As the low refractive index material of the thin film **21b,** there is used $Al_2O_3$, which is a far infrared absorbing material that absorbs infrared rays at a longer wavelength range than the infrared ray reflection band set by the first $\lambda/4$ multilayer film and the second $\lambda/4$ multilayer film. Herein, five kinds of far infrared absorbing materials, namely $MgF_2$, $Al_2O_3$, $SiO_x$, $Ta_2O_5$ and $SiN_x$ have been studied. Specifically, the film thickness of an $MgF_2$ film, an $Al_2O_3$ film, an $SiO_x$ film, a $Ta_2O_5$ film and an $SiN_x$, film was set to 1 $\mu m$, and the film formation conditions on a Si substrate were set as given in Table 1 below. Results of the measurement of the transmission spectra of the $MgF_2$ film, the $Al_2O_3$ film, the $SiO_x$ film, the $Ta_2O_5$ film and the $SiN_x$ film are illustrated in Fig. 9. An ion beam assisted deposition apparatus was used as the film formation apparatus for forming the $MgF_2$ film, the $Al_2O_3$ film, the $SiO_x$ film, the $Ta_2O_5$ film and the $SiN_x$ film.

Table 1

|  |  | $MgF_2$ | $Al_2O_3$ | $SiO_x$ | $Ta_2O_5$ | $Si_3N_4$ |
|---|---|---|---|---|---|---|
| Refractive index |  | 1.38 | 1.68 | 1.70 | 2.10 | 2.30 |
| Film formation conditions | Common conditions | Substrate: Si substrate, film thickness 1 $\mu m$, vapor deposition rate: 5 Å/sec, substrate temperature: 250˚C |  |  |  |  |
|  | IB conditions | No IB | Oxygen IB | No IB | Oxygen IB | Ar IB |

In Table 1, "IB conditions" denote the conditions of ion beam assisting during film formation using the ion beam assisted deposition apparatus. "No IB" denotes no ion beam irradiation, "oxygen IB" denotes irradiation of an oxygen ion beam and "Ar IB" denotes irradiation of an argon ion beam. In Fig. 9, the abscissa axis represents wavelength and the ordinate axis represents transmittance. In the figure, **"A1"** denotes the transmission spectrum of the $Al_2O_3$ film, **"A2"** denotes that of the $Ta_2O_5$ film, **"A3"** denotes that of the $SiO_x$ film, **"A4"** denotes that of the $SiN_x$ film, and **"A5"** denotes that of the $MgF_2$ film, respectively.

The above-described $MgF_2$ film, $Al_2O_3$ film, $SiO_x$ film, $Ta_2O_5$ film and $SiN_x$ film were evaluated for "optical characteristic : absorption", "refractive index" and "ease of film formation". The results are given in Table 2 below.

Table 2

|  | $MgF_2$ | $Al_2O_3$ | $SiO_x$ | $Ta_2O_5$ | $Si_3N_4$ |
|---|---|---|---|---|---|
| Optical characteristic : absorption | ✕ | ◯ | △ | ◯ | △ |
| Refractive index | ◎ | ◯ | ◯ | △ | △ |
| Ease of film formation | △ | ◎ | △ | ◯ | △ |

The evaluation item "optical characteristic : absorption" was evaluated on the basis of the absorption factor of far infrared rays of 6 $\mu m$ or longer, calculated on the basis of the transmission spectra of Fig. 9. The various evaluation items in Table 2 were rated as "◎" (excellent), "◯" (good), "△" (fair) and "✕" (poor) in descending order from a high-ranking evaluation. Herein, the evaluation item "optical characteristic : absorption" is given a high evaluation ranking if the far infrared absorption factor is high, and a low evaluation rank if the far infrared absorption factor is low. The evaluation item "refractive index" is given a high evaluation rank if the refractive index is low, and a low evaluation rank if the refractive index is high, from the viewpoint of increasing the refractive index difference with the high refractive index material. The evaluation item "ease of film formation" is given a high evaluation rank if a compact (dense) film is readily obtained by vapor deposition or sputtering, and is given a low evaluation rank if a compact film is not readily obtained. In the above evaluation items, $SiO_x$ was evaluated as $SiO_2$ and $SiN_x$ as $Si_3N_4$.

On the basis of Table 2, it was found that the evaluation item "ease of film formation" exhibited no significant differences between the five types, $MgF_2$, $Al_2O_3$, $SiO_x$, $Ta_2O_5$ and $SiN_x$. Results of the evaluation items "optical characteristic : absorption" and "refractive index" led to the conclusion that any from among $Al_2O_3$, $SiO_x$, $Ta_2O_5$ and $SiN_x$ is preferably used as the far infrared absorbing material. Far infrared absorption ability can be enhanced when $Al_2O_3$ or $T_2O_5$ is used as the far infrared absorbing material, as compared with when $SiO_x$ or $SiN_x$ is used as the far infrared absorbing material. Herein, $Al_2O_3$ is preferable to $T_2O_5$ in terms of increasing the refractive index difference with the high refractive index material. The moisture resistance of the thin film 21b formed of the far infrared absorbing material can be increased in a case where $SiN_x$ is used as the far infrared absorbing material. Using $SiO_x$ as the far

infrared absorbing material allows increasing the refractive index difference with the high refractive index material, and there can be reduced the number of stack layers in the first $\lambda/4$ multilayer film **21** and the second $\lambda/4$ multilayer film **22.**

A method for manufacturing the infrared optical filter of the present aspect will be explained next with reference to Fig. 8.

Firstly, there is carried out a "first $\lambda/4$ multilayer film-formation step" of forming a first $\lambda/4$ multilayer film **21** by alternately stacking the thin film **21b** having a predetermined physical film thickness (herein, 588 nm) formed of $Al_2O_3$ as a low refractive index material, and the thin film **21a** having a predetermined physical film thickness (herein, 250 nm) formed of Ge as a high refractive index material, on the entire surface of one surface side of the substrate 1 formed of Si. Next, there is carried out a "wavelength selection layer film-formation step" of forming the wavelength selection layer **23$_1$** on the entire surface of said one surface side of the substrate **1** (herein, on the surface of the first $\lambda/4$ multilayer film **21**), wherein the optical film thickness of the wavelength selection layer **23$_1$** is set in accordance with the selection wavelength of one filter part **2$_1$,** and the wavelength selection layer **23$_1$** is formed of a material (herein, $Al_2O_3$ being a low refractive index material) identical to that of the thin film **21b** positioned second from the top of the first $\lambda/4$ multilayer film **21,** thereby to yield the structure illustrated in Fig. 8A. The method for forming the thin films **21b, 21a** and the wavelength selection layer **23$_1$** may involve continuously forming the two kinds of thin films **21b, 21a,** when using a method such as vapor deposition or sputtering. If the low refractive index material is $Al_2O_3$ as described above, however, it is preferable to use ion beam assisted deposition to irradiate an oxygen ion beam during formation of the thin film **21b** so as to increase the compactness of the thin film **21b.** Also, $SiO_x$, $T_2O_5$ or $SiN_x$, which are far infrared absorbing materials, can be used as the low refractive index material, other than $Al_2O_3$. In any case, the thin film **21b** formed of a far infrared absorbing material is preferably formed by ion beam assisted deposition. This allows controlling precisely the chemical composition of the thin film **21b** that is of a low refractive index material, while increasing the compactness of the thin film **21b.**

After the above-described wavelength selection layer film-formation step, there is carried out a "resist layer formation step" of forming a resist layer **31** that covers only the site corresponding to the filter part **2$_1$,** by photolithography, to yield the structure illustrated in Fig. 8B.

Thereafter, there is carried out a "wavelength selection layer patterning step" of selectively etching an unwanted portion in the wavelength selection layer **23$_1$,** using the resist layer **31** as a mask, and using the topmost thin film **21a** of the first $\lambda/4$ multilayer film **21** as an etching stopper layer, to yield the structure illustrated in Fig. 8C. In the wavelength selection layer patterning step, if the low refractive index material is an oxide ($Al_2O_3$) and the high refractive index material is a semiconductor material (Ge), as described above, then etching can be performed, with higher etching selectivity than in dry etching, by adopting wet etching using a hydrofluoric acid solution as the etching solution. That is because oxides such as $Al_2O_3$ and $SiO_2$ are readily soluble in a hydrofluoric acid solution, whereas Ge is very hard to dissolve in a hydrofluoric acid solution. As an example, if wet etching is performed using a hydrofluoric acid solution in the form of dilute hydrofluoric acid composed of a mixed liquid of hydrofluoric acid (HF) and pure water ($H_2O$) (for instance, dilute hydrofluoric acid having a concentration of hydrofluoric acid of 2%), then the etching rate of $Al_2O_3$ is about 300 nm/min, and etching can be carried out with high etching selectivity, in that the etching-rate ratio between $Al_2O_3$ and Ge of about 500:1.

After the above-described wavelength selection layer patterning step, there is performed a "resist layer removal step" of removing the resist layer **31,** to yield the structure illustrated in Fig. 8D.

After the above-described resist layer removal step, there is carried out a "second $\lambda/4$ multilayer film-formation step" of forming the second $\lambda/4$ multilayer film **22** by alternately stacking the thin film **21a** having a predetermined physical film thickness (250 nm) formed of Ge as a high refractive index material, and the thin film **21b** having a predetermined physical film thickness (588 nm) formed of $Al_2O_3$ as a low refractive index material, on the entire surface of the one surface side of the substrate **1,** to yield the infrared optical filter having the structure illustrated in Fig. 8E. As a result of the second $\lambda/4$ multilayer film-formation step, the thin film **21a** of the lowermost layer of the second $\lambda/4$ multilayer film **22** is stacked directly on the thin film **21a** of the topmost layer of the first $\lambda/4$ multilayer film **21,** at a region corresponding to the filter part **2$_2$.** Thus, the wavelength selection layer **23$_2$** of the filter part **2$_2$** is made up of said topmost-layer thin film **21a** and said lowermost-layer thin film **21a.** The transmission spectrum of the filter part **2$_2$** corresponds to a case in which the optical film thickness "nd" is 0 nm in the simulation result of Fig. 6. The film formation method of the thin films **21a, 21b** may involve, for instance, continuously forming the two kinds of thin films **21a, 21b,** when, for instance, vapor deposition, sputtering or the like is used. If the low refractive index material is $Al_2O_3$ as described above, however, it is preferable to use ion beam assisted deposition, to increase the compactness of the thin film **21b** through irradiation of an oxygen ion beam during formation of the thin film **21b.**

In summary, the manufacturing method of the infrared optical filter of the present aspect involves performing once a wavelength selection layer formation step, in halfway during a basic step, where the basic step is composed of alternately stacking a plurality of kinds (herein, two kinds) of thin films **21b, 21a** having different refractive indices but an identical optical film thickness, on the one surface side of the substrate **1.** Herein, the wavelength selection layer formation step is composed of: a wavelength selection layer film-formation step of forming, on the stacked film (herein,

first $\lambda/4$ multilayer film **21**) at the halfway of the basic step, a wavelength selection layer **23$_i$** (herein, i=1) formed of a material identical to that of the second layer from the top of the abovementioned stacked film, wherein the optical film thickness of the wavelength selection layer **23$_i$** is set in accordance with the selection wavelength of one arbitrary filter part **2$_i$** (herein, i=1) from among a plurality of filter parts **2$_1$, ..., 2$_m$** (herein, m=2); and a wavelength selection layer patterning step of etching an unwanted portion in the wavelength selection layer **23** formed in the wavelength selection layer film-formation step, where the unwanted portion is a portion other than a portion corresponding to the abovementioned arbitrary one filter part **2$_i$**, by using an uppermost layer of the abovementioned stacked film as an etching stopper layer. Thereby, a plurality of filter parts **2$_1$, 2$_2$** is formed. Thus, an infrared optical filter having more selection wavelengths can be produced by performing the wavelength selection layer formation step a plurality of times halfway during the above-described basic step. An infrared optical filter that senses all the above-described gases can thus be realized in one chip.

The above-described manufacturing method comprises the steps of, halfway during a basic step of stacking a plurality of kinds of thin films **21a, 21b** on the one surface side of the substrate **1,** forming a thin film formed of the material identical to that of the second layer from the top of the stacked film (herein, the first $\lambda/4$ multilayer film **21**) at the halfway of the basic step, such that the optical film thickness of the thin film is set in accordance with the selection wavelength of one arbitrary filter part **2$_i$** (herein, i=1) from among filter parts **2$_1$,..., 2$_m$** (herein, m=2); and etching of a portion, in the thin film formed on the abovementioned stacked film, other than a portion corresponding to the above-mentioned one arbitrary filter part **2$_i$** (herein, i=1), thereby at least one pattern of the wavelength selection layer **23$_1$** is formed. However, there may be patterned at least one wavelength selection layer **23$_1$.** For instance, in a case where the material of a wavelength selection layer **23$_2$** is formed of the same material as the wavelength selection layer **23$_1$** and has an optical film thickness set to be smaller than that of the wavelength selection layer **23$_1$**, the patterns of two wavelength selection layers **23$_1$, 23$_2$** may be formed by etching the thin film on the abovementioned stacked film up to halfway of the thin film.

The manufacturing method is not limited thereto the above-described one, and wavelength selection layers **23$_1$,..., 23m** (herein, m=2) having mutually different optical film thicknesses at respective sites corresponding to each filter part **2$_1$,..., 2$_m$** (herein, m=2) may be formed through mask vapor deposition, between the first $\lambda/4$ multilayer film-formation step of forming the first $\lambda/4$ multilayer film **21** on the one surface side of the substrate **1**, and the second $\lambda/4$ multilayer film-formation step of forming the second $\lambda/4$ multilayer film **22** over the first $\lambda/4$ multilayer film **21**, on the reverse side of the side of the substrate **1**.

In a case where in the above-described manufacturing method the far infrared absorbing material of the thin film **21b,** which is one of the above-described two kinds of thin films **21a, 21b,** is $SiO_x$ or $SiN_x$, and the other thin film **21a** is of Si, then, the two kinds of thin films **21a, 21b** can share the same evaporation source by employing an ion beam assisted deposition apparatus having Si as the evaporation source, in such a manner of employing a vacuum atmosphere during formation of the thin film **21a** of Si, irradiating an oxygen ion beam during formation of the thin film **21b** of $SiO_x$ as an oxide, and irradiating a nitrogen ion beam during formation of the thin film **21b** of $SiN_x$ as a nitride. Therefore, it becomes unnecessary to prepare an ion beam assisted deposition apparatus provided with a plurality of evaporation sources, and manufacturing costs can be cut accordingly. In a case where in the above-described manufacturing method the far infrared absorbing material of the thin film **21b,** which is one of the above-described two kinds of thin films **21a, 21b,** is $SiO_x$ or $SiN_x$, and the other thin film **21a** is of Si, then, the two kinds of thin films **21a, 21b** can share a target by employing a sputtering apparatus that uses Si as the target, in such a manner of using, a vacuum atmosphere during formation of the thin film **21a** of Si, an oxygen atmosphere during formation of the thin film **21b** of $SiO_x$, and a nitrogen atmosphere during formation of the thin film **21b** of $SiN_x$. Therefore, it becomes unnecessary to prepare a sputtering apparatus provided with a plurality of targets, and manufacturing costs can be cut accordingly.

The infrared optical filter of the present aspect explained above has infrared ray blocking performance over a wide band, from the near infrared to the far infrared, by virtue of the light interference effect of the first $\lambda/4$ multilayer film **21** and the second $\lambda/4$ multilayer film 22, and by virtue of the far infrared ray absorption effect of the far infrared absorbing material of one of the thin films included in the first $\lambda/4$ multilayer film **21** and the second $\lambda/4$ multilayer film **22**. As a result, infrared ray blocking performance over a wide band, from the near infrared to the far infrared, can be realized, at a low cost, thanks to the light interference effect of the first $\lambda/4$ multilayer film **21** and the second $\lambda/4$ multilayer film 22, and by virtue of the far infrared ray absorption effect of the thin film **21b** included in the first $\lambda/4$ multilayer film **21** and the second $\lambda/4$ multilayer film **22**. A low-cost infrared optical filter can be realized therefore that has infrared ray blocking performance over a wide band, from the near infrared to the far infrared, and that enables selective transmission of infrared rays of a desired selection wavelength. In the infrared optical filter of the present aspect, an oxide or a nitride is used as the far infrared absorbing material that is the material of the thin film **21b**. Therefore, it becomes possible to prevent changes in optical characteristics that result from oxidation of the thin film **21b** that is of the far infrared absorbing material, from among the plurality of kinds of thin films **21a, 21b.** Besides, it becomes possible to form the thin film **21b** of the far infrared absorbing material in accordance with an ordinary thin film formation method, such as vapor deposition or sputtering. Costs are thus lower.

In the infrared optical filter of the present aspect, the thin film **21a** formed of Ge, being a material having a higher refractive index than a far infrared absorbing material, and the thin film **21b** formed of the far infrared absorbing material, are alternately stacked in the first $\lambda/4$ multilayer film **21** and the second $\lambda/4$ multilayer film **22.** Therefore, the refractive index difference between the high refractive index material and the low refractive index material in the first $\lambda/4$ multilayer film **21** and the second $\lambda/4$ multilayer film **22** can be made greater, and there can be reduced the number of stack layers in the first $\lambda/4$ multilayer film **21** and the second $\lambda/4$ multilayer film **22,** than in a case where the high refractive index material is Si or ZnS. In a case where Si is used as the high refractive index material, the refractive index difference between the high refractive index material and the low refractive index material in the first $\lambda/4$ multilayer film **21** and the second $\lambda/4$ multilayer film **22** can be made greater, and the number of stack layers in the first $\lambda/4$ multilayer film **21** and the second $\lambda/4$ multilayer film **22** can be reduced, as compared with a case where ZnS is used as the high refractive index material. In the present aspect, a Si substrate is used as the substrate **1**, and hence costs can be lowered compared with a case in which the substrate **1** is a Ge substrate, a ZnS substrate, a sapphire substrate or the like.

The infrared optical filter of the present aspect comprises a plurality of filter parts $2_1$, $2_2$ such that the optical film thickness of the wavelength selection layers $23_1$, $23_2$ at the respective filter parts $2_1$, $2_2$ are dissimilar, as described above. Therefore, infrared rays of a plurality of selection wavelengths can be selectively transmitted.

In the above-described infrared optical filter of the present aspect, $Al_2O_3$ or $SiO_x$ is used as the low refractive index material in the first $\lambda/4$ multilayer film **21** and the second $\lambda/4$ multilayer film **22,** and Ge is used as the high refractive index material. As a result, the refractive index difference between the high refractive index material and the low refractive index material can be increased as compared with a case in which both the high refractive index material and the low refractive index material are semiconductor materials. The reflectance bandwidth $\Delta\lambda$ can be widened accordingly, and there can be expanded the range in which selection wavelengths can be set by selecting the film thickness of the wavelength selection layers $23_1$, $23_2$. The degree of freedom in the design of the selection wavelength can be increased as a result. In the infrared optical filter of the present aspect, the materials of the wavelength selection layers $23_1$, $23_2$ are identical to the materials of the thin films **21b, 21a** that are second from the top of the first $\lambda/4$ multilayer film **21.** This allows, therefore, increasing the etching selectivity in a case where the wavelength selection layer $23_1$ is patterned through etching, and preventing a decrease in the optical film thickness of the thin film **21a** of the topmost layer (see Fig. 8C) of the first $\lambda/4$ multilayer film **21** during the above-mentioned patterning. Besides, in the second $\lambda/4$ multilayer film **22,** those thin films **21b, 21b** that are furthest from the substrate **1** are formed of the above-described low refractive index material. This allows preventing changes in the properties of the thin films that are furthest from the substrate in the filter parts arisen from, for instance, reactions with moisture, oxygen and the like in air, or adhesion and/or adsorption of impurities. The stability of the filter performance is thus improved. In addition, the reflection at the surfaces of the filter parts $2_1$, $2_2$ can be reduced, thus the filter performance can be enhanced.

In the infrared optical filter of the present aspect, Ge is used as the high refractive index material, and $Al_2O_3$ or $SiO_2$ is used as the low refractive index material. Therefore, infrared rays of a wide band can be blocked even when using a Si substrate as the substrate **1**. Also, an infrared optical filter having the above-described transmission peak wavelengths of 3.8 $\mu$m and a 4.3 $\mu$m can be realized in one chip, as illustrated in Fig. 10, by appropriately setting the respective optical film thickness "nd" of the above-described wavelength selection layers $23_1$, $23_2$.

The first $\lambda/4$ multilayer film **21** and the second $\lambda/4$ multilayer film **22** are only necessary to have a periodic refractive index structure, and may be stacks of three or more types of thin film.

A yet further invention is explained next.

(Background of the Invention)

Patent documents 1, 3, 4 disclose infrared optical filters provided with a semiconductor substrate (for instance, a Si substrate, a Ge substrate or the like), and a narrow-band transmission filter part formed on one surface side of the semiconductor substrate, wherein the narrow-band transmission filter part includes a wavelength selection layer (spacer layer), for transmission of infrared rays of a desired selection wavelength, which is provided halfway a stacked structure of two kinds of thin films having mutually dissimilar refractive indices but an identical optical film thickness. Patent documents 1 to 3 disclose also infrared optical filters comprising a plurality of narrow-band transmission filter parts formed on the one surface side of the semiconductor substrate, in order to enable transmission of infrared rays of a plurality of selection wavelengths.

In the above-described narrow-band transmission filter parts, wavelength selection layers having dissimilar optical film thickness are provided in the periodic refractive index structure of the stacked structure of two kinds of thin films, to introduce thereby some local disarray in the periodic refractive index structure. According to the constitution, a transmission band of narrower spectral width than the reflectance bandwidth can be localized in the reflection band, where the reflectance bandwidth is determined in accordance with the refractive index difference of the two kinds of thin films that make up the periodic refractive index structure. The transmission peak wavelength of the transmission band can be modified by appropriately varying the optical film thickness of the wavelength selection layer.

The range over which the transmission peak wavelength can shift through modulation of the optical film thickness of the wavelength selection layer depends on the reflectance bandwidth of the periodic refractive index structure, such that the wider the reflectance bandwidth is, the wider becomes the range over which the transmission peak wavelength can shift. Herein, when $n_H$ denotes the refractive index of the above-described high refractive index material, $n_L$ denotes the refractive index of the low refractive index material, $\lambda_0$ denotes a set wavelength equivalent to four times the optical film thickness, which is common to said thin films, and $\Delta\lambda$ denotes the reflectance bandwidth, in order to widen the reflectance bandwidth $\Delta\lambda$, it is important to increase the value of the refractive index ratio $n_H/n_L$, i.e. it is important to increase the refractive index difference between the high refractive index material and the low refractive index material. As illustrated in a transmission spectrum diagram shown in Fig. 21, where the abscissa axis represents the wave number, i.e. the reciprocal of the wavelength, of incident light and the ordinate axis represents the transmittance, the reflection band is symmetrical with respect to $1/\lambda_0$.

Regarding the two kinds of thin films in Patent document 1, PbTe is used as the high refractive index material, and ZnS is used as the low refractive index material, whereas Si is used as the high refractive index material in Patent documents 2, 3. Herein, Ge could conceivably be used as the high refractive index material and ZnS as the low refractive index material in order that increasing the refractive index difference.

Patent documents 5, 6 disclose the feature of using a combination of a narrow-band bandpass filter and a light blocking filter, wherein the bandpass filter is formed of a Si substrate or the like and configured to transmit infrared rays of a desired selection wavelength, and the light blocking filter is formed using a sapphire substrate and configured to block far infrared rays. In this configuration, far infrared rays in ambient light, for instance solar light, illumination light or the like can be blocked by providing such a light blocking filter.

Conceivable methods for forming each thin film and the wavelength selection layer in the narrow-band transmission filter parts of the above-described infrared optical filters include ordinary thin film formation methods such as vapor deposition, sputtering or the like.

The infrared optical filters disclosed in Patent documents 1, 3, 4 could conceivably be used for controlling infrared rays in a wavelength range from 800 nm to 20000 nm. However, blocking of far infrared rays requires providing separately the light blocking filter formed of a sapphire substrate for blocking the far infrared rays, in the same way as in Patent documents 5, 6. However, sapphire substrates are more expensive than semiconductor substrates, and entail higher costs. As a result, this limits the scope for cost reduction in, for instance, gas sensors and flame detection sensors that utilize the infrared optical filters. Meanwhile, infrared optical filters that use Ge as the high refractive index material and ZnS as the low refractive index material in narrow-band transmission filter parts require 70 or more stacked layers of two kinds of thin films in order to realize far infrared ray blocking performance without having to provide separately a light blocking filter of a sapphire substrate. This drives up manufacturing costs and may give rise to cracking of the narrow-band transmission filter parts.

(Problem to be Solved by the Invention)

In the light of the above-described issues, it is an object of the present invention to provide a low-cost infrared optical filter having infrared ray blocking performance over a wide band, from the near infrared to the far infrared.

(Means for Solving the Problem)

An infrared optical filter of the present invention is an infrared optical filter that controls infrared rays in a wavelength range from 800 nm to 20000 nm. The infrared optical filter of the present invention comprises a semiconductor substrate and a wide-band blocking filter part formed on one surface side of the semiconductor substrate. The wide-band blocking filter part is formed of a multilayer film in which a plurality of kinds of thin films having different refractive indices is stacked. At least one kind of thin film from among the plurality of kinds of thin films is formed of a far infrared absorbing material that absorbs far infrared rays.

In this case, the light interference effect elicited by the multilayer film, and the far infrared ray absorption effect elicited by said thin film included in the multilayer film, allow realizing infrared ray blocking performance over a wide band from the near infrared to the far infrared, without employing a sapphire substrate. Thus, it can be realized a low-cost infrared optical filter having infrared ray blocking performance over a wide band, from the near infrared to the far infrared.

Preferably, the far infrared absorbing material is an oxide or a nitride.

In this case, it becomes possible to prevent changes in optical characteristics, which might be caused by oxidation, of the thin film formed of the far infrared absorbing material.

Using $Al_2O_3$ as the far infrared absorbing material allows increasing the far infrared absorption ability as compared with a case in which $SiO_x$ or $SiN_x$ is used as the far infrared absorbing material.

Using $Ta_2O_5$ as the far infrared absorbing material allows increasing the far infrared absorption ability as compared with a case in which $SiO_x$ or $SiN_x$ is used as the far infrared absorbing material.

Using $SiN_x$ as the far infrared absorbing material allows increasing the moisture resistance of the thin film that is formed of the far infrared absorbing material.

Using $SiO_x$ as the far infrared absorbing material allows increasing the refractive index difference in the multilayer film, and reducing the number of stack layers in the multilayer film.

The multilayer film, preferably, is formed by alternately stacking the thin film formed of Ge, where Ge is a material having a higher refractive index than the far infrared absorbing material, and the thin film formed of the far infrared absorbing material.

In this case, the refractive index difference between the high refractive index material and the low refractive index material in the multilayer film can be increased, and also the number of stack layers in the multilayer film can be reduced, as compared with a case in which Si, PbTe or ZnS is used as the high refractive index material.

The multilayer film, preferably, is formed by alternately stacking the thin film formed of Si, where Si is a material having a higher refractive index than the far infrared absorbing material, and the thin film formed of the far infrared absorbing material.

In this case, the refractive index difference between the high refractive index material and the low refractive index material in the multilayer film can be increased, and also the number of stack layers in the multilayer film can be reduced, as compared with a case in which ZnS is used as the high refractive index material.

Preferably, the semiconductor substrate is a Si substrate.

This allows reducing costs compared with a case where the semiconductor substrate is a Ge substrate or a ZnS substrate.

(Aspects of the Invention)

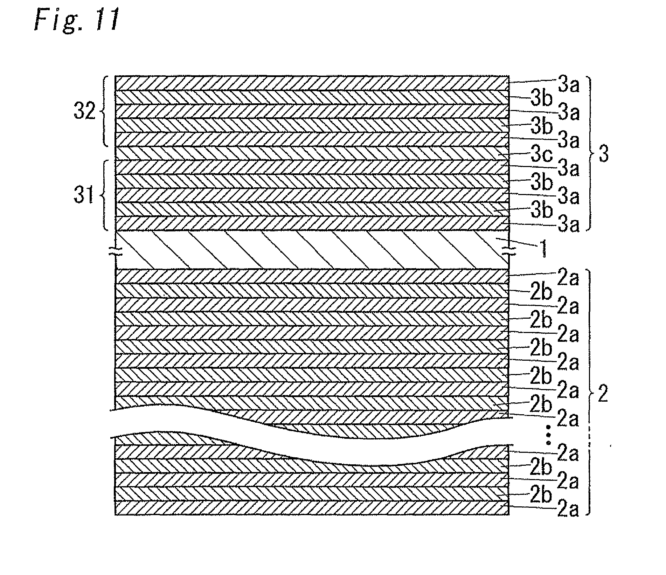

An infrared optical filter of the present aspect is an infrared optical filter for controlling infrared rays in a wavelength range from 800 nm to 20000 nm. The infrared optical filter of the present aspect is provided with, as illustrated in Fig. 11, a semiconductor substrate **1,** a wide-band blocking filter part **2** formed on one surface side (bottom side in Fig. 11) of the semiconductor substrate **1** and a narrow-band transmission filter part **3** formed on the other surface side (top side in Fig. 11) of the semiconductor substrate **1.**

As the semiconductor substrate **1** there is used a Si substrate, but the semiconductor substrate **1** is not limited to a Si substrate, and there may be used a Ge substrate, a ZnS substrate or the like. In the present aspect, the plan-view shape of the semiconductor substrate **1** is a square plan-view shape of several $mm^2$, but the plan-view shape and dimensions of the semiconductor substrate **1** are not particularly limited.

The wide-band blocking filter part **2** is made up of a multilayer film in which there are stacked a plurality of kinds (herein, two kinds) of thin films **2a, 2b** having dissimilar refractive indices. In the wide band transmission filter part **2**, $Al_2O_3$, which is one kind of far infrared absorbing material having far infrared ray absorption property, is used as the material of the thin film **2a** that is a low refractive index layer having a relatively low refractive index, while Ge is used as the material of the thin film **2b** that is a high refractive index layer having a relatively high refractive index. Herein, the thin film **2a** and the thin film **2b** are alternately stacked in such a manner that there are 11 stacked layers, but the number of stack layers is not particularly limited thereto. In the wide-band blocking filter part **2,** from the viewpoint of the stability of optical characteristic, the topmost layer that is furthest from the semiconductor substrate **1** is preferably made up of a thin film **2a** that is the low refractive index layer. The far infrared absorbing material is not limited to $Al_2O_3$, and may be an oxide other than $Al_2O_3$, for instance $SiO_2$ or $Ta_2O_5$. Herein, $SiO_2$ has a lower refractive index than $Al_2O_3$, and hence there can be achieved a greater refractive index difference between the high refractive index material and the low refractive index material. $SiN_x$, which is a nitride, can be used as the far infrared absorbing material.

In the wide-band blocking filter part **2,** as described above, the thin film **2a,** being one of the two kinds of thin films **2a, 2b,** is formed of $Al_2O_3$, which is a far infrared absorbing material that absorbs far infrared rays. Herein, the wide-band blocking filter part **2** may be formed of plurality of kinds of materials at least one of which is a far infrared absorbing material. The multilayer film may be formed by stacking, for instance, three kinds of thin films of a Ge film, an $Al_2O_3$ film and a $SiO_x$ film so that stacking a Ge film - A1203 film - Ge film - $SiO_x$ film - Ge film - A1203 film - Ge film... over the semiconductor substrate **1** in this order from the side nearest to the semiconductor substrate **1** that is of a Si substrate. In this case, two kinds of thin films from among the three kinds of thin films are formed of far infrared absorbing materials.

The narrow-band transmission filter part **3** is provided with: a periodic refractive index structure having a stacked structure of a plurality of kinds (herein, two kinds) of thin films **3a, 3b** having dissimilar refractive indices but an identical optical film thickness; and a wavelength selection layer **3c** provided halfway the periodic refractive index structure and having an optical film thickness dissimilar from that of the thin films **3a, 3b**. In the narrow-band transmission filter part **3**, a stacked film of the thin films **3a, 3b** on the side closer to the semiconductor substrate **1** than the wavelength selection layer **3c** constitutes a first $\lambda/4$ multilayer film **31**, while a stacked film of the thin films **3a, 3b** on a side further from the semiconductor substrate **1** than the wavelength selection layer **3c** constitutes a second $\lambda/4$ multilayer film **32** (that is, the wavelength selection layer **3c** is interposed between the first $\lambda/4$ multilayer film **31** and the second $\lambda/4$ multilayer film **32**).

In the narrow-band transmission filter part **3**, $Al_2O_3$, which is one kind of far infrared absorbing material that absorbs far infrared rays, is used as the material of the thin film **3a** that is a low refractive index layer having a relatively low refractive index, while Ge is used as the material of the thin film **3b** that is a high refractive index layer having a relatively high refractive index. The thin film **3a**, the thin film **3b** and the wavelength selection layer **3c** yield a total of 29 stacked layers, but the number of stack layers is not particularly limited thereto. The far infrared absorbing material used in the narrow-band transmission filter part **3** is not limited to $Al_2O_3$, and may be an oxide other than $Al_2O_3$, for instance $SiO_2$ or $Ta_2O_5$. Herein, $SiO_2$ has a lower refractive index than $Al_2O_3$, and hence there can be achieved a greater refractive index difference between the high refractive index material and the low refractive index material. $SiN_x$, which is a nitride, can be used as the far infrared absorbing material. Herein, Si, PbTe or the like may be used instead of Ge as the high refractive index material of the narrow-band transmission filter part **3**. The low refractive index material of the narrow-band transmission filter part **3** is not limited to a far infrared absorbing material, and may be an infrared transmitting material such as ZnS. Preferably, herein, the topmost layer of the narrow-band transmission filter part **3** furthest from the semiconductor substrate **1** is made up of the thin film **3a**, which is a low refractive index layer. More preferably, the thin film **3a** of the furthest layer is made up of an oxide or a nitride, from the viewpoint of the stability of optical characteristic.

The wavelength selection layer **3c** of the narrow-band transmission filter part **3** has an optical film thickness dissimilar from the optical film thickness of the thin films **21a, 21b,** in accordance with the desired selection wavelength. Specific wavelengths for detecting (sensing) various gases and flame that can occur, for instance, in houses, include 3.3 $\mu$m for $CH_4$ (methane), 4.0 $\mu$m for $SO_3$ (sulfur trioxide), 4.3 $\mu$m for $CO_2$ (carbon dioxide), 4.7 $\mu$m for CO (carbon monoxide), 5.3 $\mu$m for NO (nitrogen monoxide) and 4.3 $\mu$m for flame. In order to sense any one of the foregoing, a set wavelength $\lambda_0$ of the first $\lambda/4$ multilayer film **31** and the second $\lambda/4$ multilayer film **32** may be set in such a manner that there is formed a reflection band that encompasses the selection wavelengths consisting of the specific wavelengths of the sensing target, and the optical film thickness of the wavelength selection layer **3c** may be appropriately set in such a way so as to localize a narrow transmission band that encompasses the selection wavelengths.

The above-described wide-band blocking filter part **2** absorbs far infrared rays of a wavelength range that is longer than the infrared reflection band set by the narrow-band transmission filter part **3.** Herein, for the wide-band blocking filter part **2**, $Al_2O_3$ is used as the far infrared absorbing material that absorbs infrared rays, but five kinds of far infrared absorbing materials, namely $MgF_2$, $Al_2O_3$, $SiO_x$, $Ta_2O_5$ and $SiN_x$ have been studied.

Specifically, the film thickness of an $MgF_2$ film, an $Al_2O_3$ film, an $SiO_x$ film, a $Ta_2O_5$ film and an $SiN_x$ film was set to 1 $\mu$m, and the film formation conditions on a Si substrate were set as given in Table 1 below. Results of the measurement of the transmission spectra of the $MgF_2$ film, the $Al_2O_3$ film, the $SiO_x$ film, the $Ta_2O_5$ film and the $SiN_x$ film are illustrated in Fig. 9. In Fig. 9, the abscissa axis represents wavelength and the ordinate axis represents transmittance. In the figure, **"A1"** denotes the transmission spectrum of the $Al_2O_3$ film, **"A2"** denotes that of the $Ta_2O_5$ film, **"A3"** denotes that of the $SiO_x$ film, **"A4"** denotes that of the $SiN_x$ film, and **"A5"** denotes that of the $MgF_2$ film, respectively.

Table 3

| | | $MgF_2$ | $Al_2O_3$ | $SiO_x$ | $Ta_2O_5$ | $Si_3N_4$ |
|---|---|---|---|---|---|---|
| Refractive index | | 1.38 | 1.68 | 1.70 | 2.10 | 2.30 |
| Film formation conditions | Common conditions | Substrate: Si, film thickness 1 $\mu$m, vapor deposition rate: 5 Å/sec, substrate temperature: 250˚C | | | | |
| | IB conditions | No IB | Oxygen IB | No IB | Oxygen IB | Ar IB |

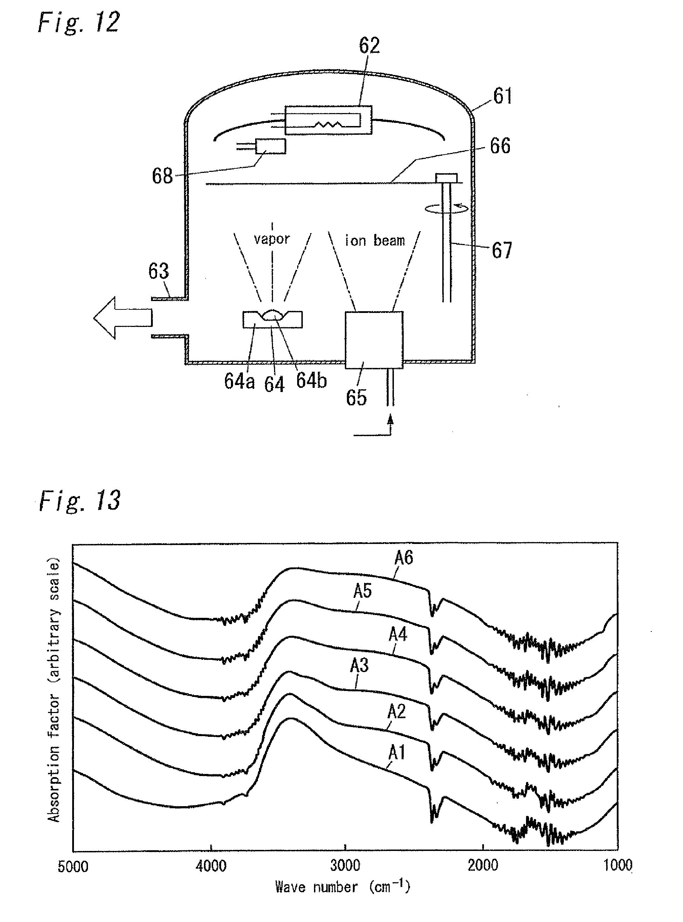

An ion beam assisted deposition apparatus was used as the film formation apparatus for the $MgF_2$ film, the $Al_2O_3$ film, the $SiO_x$ film, the $Ta_2O_5$ film and the $SiN_x$ film. As illustrated in Fig. 12, the ion beam assisted deposition apparatus comprises: a vacuum chamber **61** for film formation; a substrate holder **62** provided with a heater, where the substrate holder **62** is disposed in the vacuum chamber **61** and is configured to hold the semiconductor substrate **1;** an evacuation pipe **63** for evacuating the interior of the vacuum chamber **61;** an electron gun **64** where an evaporation source **64b** is placed in a crucible **64a;** an RF-type ion source **65** for emitting ion beams; a shutter **66** that can turn, through turning of a shutter shaft **67,** between a position that enables a vapor from the evaporation source **64b** as well as ion beams from the RF-type ion source **65** to pass towards the substrate holder **62** provided with a heater, and a position such that the vapor and the ion beams are prevented from passing; and an optical monitor **68** comprising an optical-type film thickness meter for detecting the thickness of the film that is formed on the semiconductor substrate **1**.

In Table 3, "IB conditions" denote the conditions of ion beam assisting during film formation using the ion beam assisted deposition apparatus, such that "no IB" denotes no ion beam irradiation, "oxygen IB" denotes irradiation of an oxygen ion beam and "Ar IB" denotes irradiation of an argon ion beam.

In order to check the effect of ion beam assisting, the inventors of the present application prepared samples with various ion beam irradiation doses upon formation of the $Al_2O_3$ film on the Si substrate. The difference in film quality of the $Al_2O_3$ film of the samples was analyzed by FT-IR (Fourier transform infrared spectroscopy). Fig. 13 indicates the analysis results by FT-IR. In Fig. 13, the abscissa axis represents the wave number and the ordinate axis represents the absorption factor (absorptance). In the figure, **"A1"** denotes a sample in an instance of no ion beam assisting, and **"A2", "A3", "A4", "A5"** and **"A6"** represent the results of analysis of respective samples in instances where the ion beam irradiation dose varied from a small to a large dose. It is found that the absorption factor around 3400 $cm^{-1}$, which arises from water, can be reduced through irradiation of ion beams, and that the greater the ion beam irradiation dose is, the lower becomes the absorption factor around 3400 $cm^{-1}$, arising from water. In brief, ion beam assisting allows improving the film quality of the $Al_2O_3$ film, and is expected to make for higher compactness.

The above-described $MgF_2$ film, $Al_2O_3$ film, $SiO_x$ film, $Ta_2O_5$ film and $SiN_x$ film were evaluated for "optical characteristic : absorption", "refractive index" and "ease of film formation". The results are given in Table 4 below.

Table 4

|  | $MgF_2$ | $Al_2O_3$ | $SiO_x$ | $Ta_2O_5$ | $Si_3N_4$ |
|---|---|---|---|---|---|
| Optical characteristic : absorption | × | ○ | △ | ○ | △ |
| Refractive index | ◎ | ○ | ○ | △ | △ |
| Film formation ease | △ | ◎ | △ | ○ | △ |

The evaluation item "optical characteristic : absorption" was evaluated on the basis of the absorption factor of far infrared rays of 6 $\mu$m or longer, calculated on the basis of the transmission spectra of Fig. 9. The various evaluation items in Table 4 were rated as "◎" (excellent), "○" (goof), "△" (fair) and "×" (poor) in descending order from a high-ranking evaluation. Herein, the evaluation item "optical characteristic : absorption" is given a high evaluation ranking if the far infrared absorption factor is high, and a low evaluation rank if the far infrared absorption factor is low. The evaluation item "refractive index" is given a high evaluation rank if the refractive index is low, and a low evaluation rank if the refractive index is high, from the viewpoint of increasing the refractive index difference with the high refractive index material. The evaluation item "ease of film formation" is given a high evaluation rank if a compact (dense) film is readily obtained by vapor deposition or sputtering, and is given a low evaluation rank if a compact film is not readily obtained. In the various evaluation items, $SiO_x$ was evaluated as $SiO_2$, and $SiN_x$ as $Si_3N_4$.

On the basis of Table 4, it was found that the evaluation item "ease of film formation" exhibited no significant differences between the five types, $MgF_2$, $Al_2O_3$, $SiO_x$, $Ta_2O_5$ and $SiN_x$. Results of the evaluation items "optical characteristic : absorption" and "refractive index" led to the conclusion that any from among $Al_2O_3$, $SiO_x$, $Ta_2O_5$ and $SiN_x$ is preferably used as the far infrared absorbing material. Far infrared absorption ability can be enhanced when $Al_2O_3$ or $T_2O_5$ is used as the far infrared absorbing material, as compared with when $SiO_x$ or $SiN_x$ is used as the far infrared absorbing material. Herein, $Al_2O_3$ is preferable to $T_2O_5$ in terms of increasing the refractive index difference with the high refractive index material. The moisture resistance of the thin film **2a** formed of the far infrared absorbing material can be increased in a case where $SiN_x$ is used as the far infrared absorbing material. Using $SiO_x$ as the far infrared absorbing material allows increasing the refractive index difference with the high refractive index material, and allows reducing the number of stack layers of the thin film **2a** and the thin film **2b.**

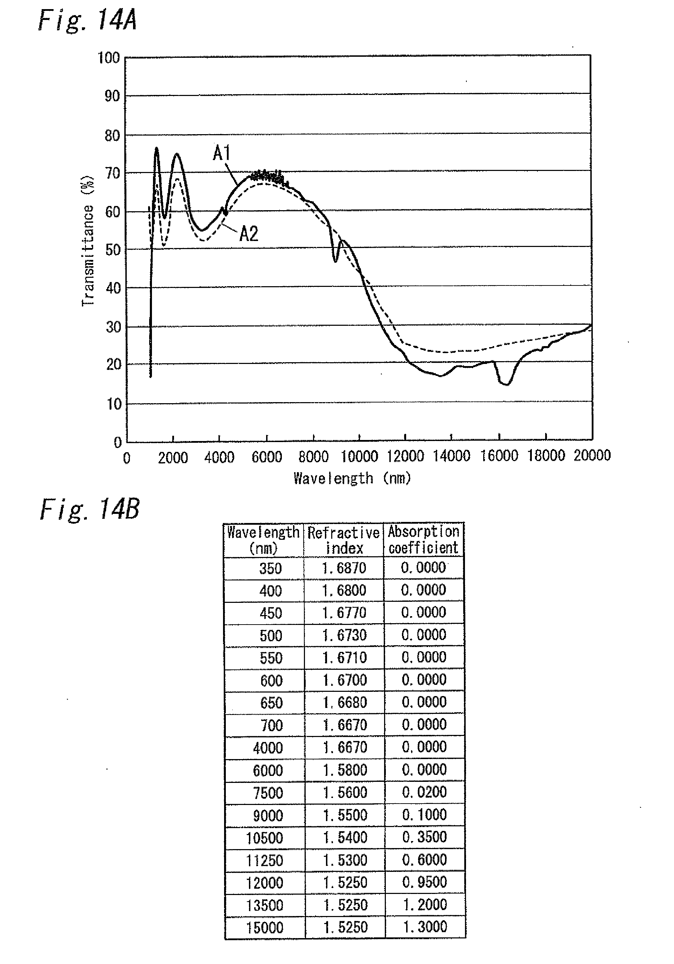

The inventors of the present application performed measurements of the transmission spectra of a reference example in which a 1 $\mu$m $Al_2O_3$ film was formed on a Si substrate. The actually measured values were such as those illustrated by **"A1"** in Fig. **14A.** It was found that the actually measured value **"A1"** deviated from the calculated value illustrated by **"A2"** in Fig. 14A. Then, the optical parameters (refractive index, absorption coefficient) of the thin film **2a** formed of $Al_2O_3$ was calculated according to the Cauchy formula, on the basis of the actually measured value **"A1"** in Fig. 14A. The calculated optical parameters are illustrated in Fig. 14B. In the novel optical parameters illustrated in Fig. 14B, neither the refractive index nor the absorption coefficient is constant throughout the wavelength range from 800 nm to 20000 nm. Instead, the refractive index decreases gradually as the wavelength lengthens, while the absorption coefficient increases gradually as the wavelength lengthens in the wavelength range from 7500 nm to 15000 nm.

Tables 5 and 6 illustrate a design example of the film thickness (physical film thickness) of the multilayer film of the wide-band blocking filter part **3** and that of the narrow-band transmission filter part **2,** of a working example of the infrared optical filter in which the wavelength of a narrow-band bandpass filter was designed to a 4.4 $\mu$m, using the

above-described novel optical parameters of the $Al_2O_3$ film. A simulation result of the transmission spectrum of this working example is illustrated as **"A1"** in Fig. 15. In Fig. 15, **"A2"** illustrates a simulation result of a comparative example in which the above-described novel optical parameters of the $Al_2O_3$ film were not used, but instead, the absorption coefficient was constant, of 0, and the refractive index of the $Al_2O_3$ film was constant. In the simulations of both the working example and the comparative example, the refractive index of Ge was set to be constant, of 4.0, and the absorption coefficient of which was also set to be constant, of 0.0.

Table 5

| Constituent element | Film type | Film thickness (nm) |
|---|---|---|
| Thin film **3a** | $Al_2O_3$ | 600 |
| Thin film **3b** | Ge | 230 |
| Thin film **3a** | $Al_2O_3$ | 600 |
| Thin film **3b** | Ge | 230 |
| Thin film **3a** | $Al_2O_3$ | 600 |
| Wavelength selection layer **3c** | Ge | 460 |
| Thin film **3a** | $Al_2O_3$ | 600 |
| Thin film **3b** | Ge | 230 |
| Thin film **3a** | $Al_2O_3$ | 600 |
| Thin film **3b** | Ge | 230 |
| Thin film **3a** | $Al_2O_3$ | 600 |
| Semiconductor substrate **1** | Si substrate | - |

Table 6

| Constituent element | Film type | Film thickness (nm) |
|---|---|---|
| Thin film **2a** | $Al_2O_3$ | 749 |
| Thin film **2b** | Ge | 73 |
| Thin film **2a** | $Al_2O_3$ | 563 |
| Thin film **2b** | Ge | 37 |
| Thin film **2a** | $Al_2O_3$ | 463 |
| Thin film **2b** | Ge | 149 |
| Thin film **2a** | $Al_2O_3$ | 254 |
| Thin film **2b** | Ge | 91 |
| Thin film **2a** | $Al_2O_3$ | 433 |
| Thin film **2b** | Ge | 517 |
| Thin film **2a** | $Al_2O_3$ | 182 |
| Thin film **2b** | Ge | 494 |
| Thin film **2a** | $Al_2O_3$ | 185 |
| Thin film **2b** | Ge | 498 |
| Thin film **2a** | $Al_2O_3$ | 611 |
| Thin film **2b** | Ge | 465 |

(continued)

| Constituent element | Film type | Film thickness (nm) |
|---|---|---|
| Thin film **2a** | $Al_2O_3$ | 626 |
| Thin film **2b** | Ge | 467 |
| Thin film **2a** | $Al_2O_3$ | 749 |
| Thin film **2b** | Ge | 513 |
| Thin film **2a** | $Al_2O_3$ | 1319 |
| Thin film **2b** | Ge | 431 |
| Thin film **2a** | $Al_2O_3$ | 1319 |
| Thin film **2b** | Ge | 86 |
| Thin film **2a** | $Al_2O_3$ | 140 |
| Thin film **2b** | Ge | 27 |
| Thin film **2a** | $Al_2O_3$ | 39 |
| Thin film **2b** | Ge | 4 |
| Thin film **2a** | $Al_2O_3$ | 15 |
| Semiconductor substrate **1** | Si substrate | - |

In Fig. 15, the abscissa axis represents the wavelength of incident light (infrared rays) and the ordinate axis represents transmittance. It shows that far infrared rays from 9000 nm to 20000 nm are not blocked in the transmission spectrum **"A2"** of the comparative example, in which the novel optical parameters of the $Al_2O_3$ film are not used. By contrast, 9000 nm to 20000 nm far infrared rays are blocked in the transmission spectrum **"A1"** of the working example where the novel optical parameters of the $Al_2O_3$ film are used. Infrared rays of a wide band, from 800 nm to 20000 nm, can be blocked by the wide-band blocking filter part **2** in which the number of stack layers is 29 layers and by the narrow-band transmission filter part **3** in which the number of stack layers is 11 layers. A narrow transmission band can thus be localized in the vicinity of 4.4 μm alone. The infrared optical filter of the present aspect is provided with the semiconductor substrate **1** of a Si substrate, the wide-band blocking filter part **2** formed on the one surface side of the semiconductor substrate **1,** and the narrow-band transmission filter part **3** formed on the other surface side of the semiconductor substrate **1.** However, infrared rays in a far infrared region of 9000 nm to 20000 nm and in a near infrared region of 800 nm to 30000 nm can be blocked by providing at least the wide-band blocking filter part **2.** In the infrared optical filter of the working example, a reflection band is set in the wavelength range of 3000 nm to 6000 nm, and the central wavelength (the above-described selection wavelength) of the transmission band that is localized in the reflection band is set to 4.4 μm, by virtue of the narrow-band transmission filter part **3.**

To manufacture the infrared optical filter of the present aspect, there may be carried out: firstly, a "wide-band blocking filter part formation step" of forming the wide-band blocking filter part **2** by alternately stacking the thin film **2a** formed of such as an $Al_2O_3$ film, and the thin film **2b** formed of such as a Ge film, on the one surface side of the semiconductor substrate **1** formed of a Si substrate; then, a "first λ/4 multilayer film-formation step" of forming the first λ/4 multilayer film **31** by alternately stacking the thin film **3a** formed of such as an $Al_2O_3$ film and the thin film **3b** formed of such as a Ge film, on the other surface side of the semiconductor substrate **1;** next, a "wavelength selection layer formation step" of forming the wavelength selection layer **3c** on the other surface side of the semiconductor substrate **1** (herein, on the first λ/4 multilayer film **31**); and a "second λ/4 multilayer film-formation step" of forming thereafter the second λ/4 multilayer film **32.**

For instance, the thin films **2a, 2b** of the wide-band blocking filter part **2** can be formed continuously, and also the first λ/4 multilayer film **31,** the wavelength selection layer **3c** and the second λ/4 multilayer film **32** of the narrow-band transmission filter part **3** can be formed continuously, if vapor deposition or sputtering are adopted as the method for forming the thin films **2a, 2b**, the thin films **3a, 3b** and the wavelength selection layer **3c**. However, ion beam assisted deposition is preferably used to irradiate an oxygen ion beam during formation of the thin films **2a, 3a** in a case where the low refractive index material is $Al_2O_3$, as described above, in order that the thin films **2a, 3a** can be made more compact by lowering moisture content. $SiO_x$, $T_2O_5$ or $SiN_x$, which are a far infrared absorbing material other than $Al_2O_3$, may also be used as the low refractive index material. In any case, the thin films **2a, 3a** made of a far infrared absorbing material are preferably formed by ion beam assisted deposition. Doing so allows controlling precisely the chemical composition of the thin films **2a, 3a** made of a low refractive index material, while enhancing the compactness of the thin films **2a, 3a,** and allows preventing fluctuation of the optical parameters.

In a case where in the above-described manufacturing method the far infrared absorbing material of one thin film **2a** (**3a**) from among the above-described two kinds of thin films **2a** (**3a**), **2b** (**3b**) is $SiO_x$ ($SiO_2$) or $SiN_x$ ($Si_3N_4$) and the material of the other thin film **2b** (**3b**) is Si, then the evaporation source **64** used for forming the two kinds of thin films **2a** (**3a**), **2b** (**3b**) can be shared, by using Si as the evaporation source **64b** in the ion beam assisted deposition apparatus of Fig. 12, setting the interior of the vacuum chamber **61** to a vacuum atmosphere during formation of the thin film **2b** (**3b**) of Si, irradiating an oxygen ion beam from the RF-type ion source **65** during formation of the thin film **2a** (**3a**) of $SiO_x$, which is an oxide, and irradiating a nitrogen ion beam during formation of the thin film **2a** (**3a**) of $SiN_x$, which is a nitride. Manufacturing costs can be lowered as a result, since it becomes unnecessary to prepare an ion beam assisted deposition apparatus provided with a plurality of evaporation sources. Similarly, in a case where in the above-described manufacturing method the far infrared absorbing material of one thin film **2a** (**3a**) from among the above-described two kinds of thin films **2a** (**3a**), **2b** (**3b**) is $SiO_x$ ($SiO_2$) or $SiN_x$ ($Si_3N_4$) and the material of the other thin film 2b (3b) is Si, then the targets for the two kinds of thin films **2a** (**3a**), **2b** (**3b**) can be shared, by using a sputtering apparatus that employs Si as a target, setting the interior of the vacuum chamber of the sputtering apparatus to a vacuum atmosphere during formation of the thin film **2b** (**3b**) of Si, setting an oxygen atmosphere during formation of the thin film **2a** (**3a**) of $SiO_x$, and setting a nitrogen atmosphere during formation of the thin film **2a** (**3a**) of $SiN_x$. Manufacturing costs can be lowered as a result, since it becomes unnecessary to prepare a sputtering apparatus provided with a plurality of targets.

The infrared optical filter of the present aspect explained above comprises the semiconductor substrate 1 and the wide-band blocking filter part **3** formed on the side of the one surface of the semiconductor substrate **1,** wherein the wide-band blocking filter part **3** is formed of a multilayer film in which a plurality of kinds of thin films **2a, 2b** having dissimilar refractive indices are stacked. Herein, one kind of thin film **2a** from among the plurality of kinds of thin films **2a, 2b,** is formed of a far infrared absorbing material that absorbs far infrared rays. Therefore, the light interference effect elicited by the multilayer film, and the far infrared ray absorption effect elicited by the thin film **2a** included in the multilayer film, allow realizing infrared ray blocking performance over a wide band from the near infrared to the far infrared, without employing a sapphire substrate. Thus, it allows realizing a low-cost infrared optical filter having infrared ray blocking performance over a wide band, from the near infrared to the far infrared. In brief, the wide-band blocking filter part **2** is composed of a multilayer film in which a plurality of kinds of thin films **2a, 2b** having dissimilar refractive indices are stacked, and has infrared ray blocking performance over a wide band, from the near infrared to the far infrared, by virtue of the light interference effect elicited by the multilayer film, and by virtue of the far infrared ray absorption effect elicited by the far infrared absorbing material of the thin film **2a** in the multilayer film.

In the infrared optical filter of the present aspect, the narrow-band transmission filter part **3** is formed on the side of the other surface of the semiconductor substrate **1**. Thus, the infrared optical filter of the present aspect has infrared ray blocking performance over a wide band, from the near infrared to the far infrared, by virtue of the light interference effect elicited by the first $\lambda/4$ multilayer film **31** and the second $\lambda/4$ multilayer film **32,** and by virtue of the far infrared ray absorption effect elicited by the far infrared absorbing material of the thin film **3a** in the multilayer film, where the multilayer film is made up of the first $\lambda/4$ multilayer film **31,** the wavelength selection layer **3c** and the second $\lambda/4$ multilayer film **32.** As a result, there can be realized a low-cost infrared optical filter, which has infrared ray blocking performance over a wide band, from the near infrared to the far infrared, and which selectively transmits infrared rays of a desired selection wavelength.

An oxide or a nitride is used as the far infrared absorbing material in the infrared optical filter of the present aspect. Changes in optical characteristics, arising from oxidation, of the thin films **2a, 3a** formed of the far infrared absorbing material, can be prevented thereby. In both the wide-band blocking filter part **2** and the narrow-band transmission filter part **3** of the infrared optical filter of the present aspect, the topmost layers that are furthest from the semiconductor substrate **1** are formed of the above-described oxide or nitride, respectively. This allows preventing changes in the properties of the thin films **2a, 3a** at the topmost layer on account of reactions with moisture, oxygen or the like in air, or adsorption and/or adhesion of impurities, thereby enhancing the stability of filter performance, and allows reducing reflection at the surface of the wide-band blocking filter part **2** and the narrow-band transmission filter part **3**, so that filter performance is enhanced.

In the infrared optical filter of the present aspect, a multilayer film of the wide-band blocking filter part **2** is configured through alternate stacking of the thin film **2a** formed of far infrared absorbing material, and the thin film **2b** formed of Ge, which is a material having a higher refractive index than that of the far infrared absorbing material. Therefore, the refractive index difference between the high refractive index material and the low refractive index material can be made greater, and there can be reduced the number of stack layers of the multilayer film, as compared with a case where Si, PbTe or ZnS is used as the high refractive index material. Then, when using Si as the high refractive index material, the refractive index difference between the high refractive index material and the low refractive index material can be increased, and the number of stack layers of the multilayer film can be reduced to a greater extent than when using ZnS as the high refractive index material. With respect to the narrow-band transmission filter part **3**, the number of stack layers can also be reduced, for the same reasons as set forth above. In the present aspect, a Si substrate is used as the semiconductor substrate **1**. This allows reducing costs compared with a case where the semiconductor substrate **1** is a Ge substrate or a ZnS substrate.

In the above-described infrared optical filter, one narrow-band transmission filter part **3** is provided on the other surface side of the semiconductor substrate **1**. However, the infrared optical filter may also be configured in such a manner that a plurality of narrow-band transmission filter parts **3** having mutually different selection wavelengths is arranged side by side on the other surface side of the semiconductor substrate **1** so that infrared rays of a plurality of selection wavelengths can be selectively transmitted in one chip. In this case, each the optical film thickness of the wavelength selection layer **23** may be appropriately set according to the corresponding selection wavelength of the narrow-band transmission filter part 3. In this case as well, using $Al_2O_3$ or $SiO_x$ as the low refractive index material and Ge as the high refractive index material, in the first $\lambda/4$ multilayer film **31** and the second $\lambda/4$ multilayer film **32**, allows increasing the refractive index difference between the high refractive index material and the low refractive index material, whereby there can be widened the reflectance bandwidth $\Delta\lambda$ and the selection wavelength range at which selection is enabled through setting of the film thickness of each wavelength selection layer **23,** as compared with a case where both the high refractive index material and the low refractive index material are semiconductor materials. The degree of freedom in the design of the selection wavelengths is increased as a result.

The patterning method of the wavelength selection layer **23** is not particularly limited, and may be a method that combines thin film formation techniques with photolithography techniques and etching techniques, or may be a lift-off method, or a mask vapor deposition method.

In a method that combines thin film formation techniques with photolithography techniques and etching techniques, and in a case where the low refractive index material is an oxide ($Al_2O_3$) and the high refractive index material is a semiconductor material (Ge), as described above, etching can be performed with high etching selectivity, as compared with dry etching, by adopting wet etching using a hydrofluoric acid solution as the etching solution. That is because an oxide such as $Al_2O_3$ and $SiO_2$ is readily soluble in a hydrofluoric acid solution, while Ge is very difficult to dissolve in hydrofluoric acid solution. As an example, etching can be performed with high etching selectivity, with an etching-rate ratio between $Al_2O_3$ and Ge of about 500:1, at an etching rate of $Al_2O_3$ of about 300 nm/min, by performing wet etching using a hydrofluoric acid solution in the form of dilute hydrofluoric acid composed of a mixed liquid of hydrofluoric acid (HF) and pure water ($H_2O$) (for instance, dilute hydrofluoric acid having a hydrofluoric acid concentration of 2%).

The first $\lambda/4$ multilayer film **31** and the second $\lambda/4$ multilayer film **32** may be a stack of three or more kinds of thin films, so long as the stack has a periodic refractive index structure.

The infrared optical filter explained with reference to Fig. 1 has a plurality (two in the example of the figure, but may be three or more) of filter parts **2₁, 2₂** on the one surface side of the substrate **1**. Herein, the wide-band blocking filter part **2** explained with reference to Fig. 11 may be provided on the other surface side.

**Claims**

1. An infrared optical filter comprising:

   a substrate formed of an infrared transmitting material; and
   a plurality of filter parts arranged side by side on one surface side of the substrate,
   wherein each filter part includes: a first $\lambda/4$ multilayer film in which two kinds of thin films having mutually different refractive indices but an identical optical film thickness are alternately stacked; a second $\lambda/4$ multilayer film in which the two kinds of thin films are alternately stacked, said second $\lambda/4$ multilayer film being formed on the opposite side of the first $\lambda/4$ multilayer film from the substrate side; and a wavelength selection layer interposed between the first $\lambda/4$ multilayer film and the second $\lambda/4$ multilayer film, said wavelength selection layer having an optical film thickness different from the optical film thickness of each the thin film according to a desired selection wavelength,
   wherein a low refractive index material of the first $\lambda/4$ multilayer film and the second $\lambda/4$ multilayer film is an oxide and a high refractive index material thereof is a semiconductor material of Ge, and
   wherein a material of the wavelength selection layer is identical to a material of the second top thin film of the first $\lambda/4$ multilayer film.

2. The infrared optical filter according to claim 1, wherein, in the second $\lambda/4$ multilayer film, the thin film furthest from the substrate is formed of the low refractive index material.

3. The infrared optical filter according to claim 1 or 2, wherein the low refractive index material is $Al_2O_3$ or $SiO_2$.

4. The infrared optical filter according to any one of claims 1 to 3, wherein the infrared transmitting material is Si.

5. An infrared optical filter manufacturing method, wherein the method comprises performing, halfway a basic step of alternately stacking two kinds of thin films having mutually different refractive indices but an identical optical film thickness on one surface side of a substrate, at least once a wavelength selection layer formation step, wherein the wavelength selection layer formation step includes: a wavelength selection layer film-formation step of forming a wavelength selection layer on the stacked film, said wavelength selection layer being formed of a material identical to that of the second top layer of the stacked film in said halfway of the basic step and having an optical film thickness set in accordance with a selection wavelength of one arbitrary filter part from among filter parts; and a wavelength selection layer patterning step of etching an unwanted portion in the wavelength selection layer formed in the wavelength selection layer film-formation step, by using an uppermost layer of the stacked film as an etching stopper layer, said unwanted portion being a portion other than a portion corresponding to said one arbitrary filter part.

6. An infrared optical filter that controls infrared rays in a wavelength range from 800 nm to 20000 nm, comprising:

a substrate; and
a filter part formed on one surface side of the substrate and configured to selectively transmit infrared rays of a desired selection wavelength,
wherein the filter part includes: a first $\lambda/4$ multilayer film in which a plurality of kinds of thin films having mutually different refractive indices but an identical optical film thickness are stacked; a second $\lambda/4$ multilayer film in which the plurality of kinds of thin films are stacked, said second $\lambda/4$ multilayer film being formed on the opposite side of the first $\lambda/4$ multilayer film from the substrate side; and a wavelength selection layer interposed between the first $\lambda/4$ multilayer film and the second $\lambda/4$ multilayer film, said wavelength selection layer having an optical film thickness different from the optical film thickness of each the thin film according to the selection wavelength, and
wherein at least one kind of thin film from among said plurality of kinds of thin films is formed of a far infrared absorbing material that absorbs far infrared rays of a longer wavelength range than an infrared ray reflection band set by the first $\lambda/4$ multilayer film and the second $\lambda/4$ multilayer film.

7. The infrared optical filter according to claim 6,
wherein the far infrared absorbing material is an oxide or a nitride.

8. The infrared optical filter according to claim 6,
wherein the far infrared absorbing material is $Al_2O_3$.

9. The infrared optical filter according to claim 6,
wherein the far infrared absorbing material is $Ta_2O_5$.

10. The infrared optical filter according to claim 6,
wherein the far infrared absorbing material is $SiN_x$.

11. The infrared optical filter according to claim 6,
wherein the far infrared absorbing material is $SiO_x$.

12. The infrared optical filter according to any one of claims 6 to 11, wherein the first $\lambda/4$ multilayer film and the second $\lambda/4$ multilayer film are formed by alternately stacking the thin film formed of Ge, being a material having a higher refractive index than the far infrared absorbing material, and the thin film formed of the far infrared absorbing material.

13. The infrared optical filter according to any one of claims 6 to 11, wherein the first $\lambda/4$ multilayer film and the second $\lambda/4$ multilayer film are formed by alternately stacking the thin film formed of Si, being a material having a higher refractive index than the far infrared absorbing material, and the thin film formed of the far infrared absorbing material.

14. The infrared optical filter according to any one of claims 6 to 13, wherein the substrate is a Si substrate.

15. The infrared optical filter according to any one of claims 6 to 14,
wherein the infrared optical filter comprises a plurality of the filter parts, and
wherein the optical film thickness of the wavelength selection layer of the plurality of the filter parts are different from each other.

**16.** A method for manufacturing the infrared optical filter according to claim 15,
wherein the method comprises the step of forming, halfway a basic step of stacking the plurality of kinds of thin films on one surface side of the substrate, at least one pattern of the wavelength selection layer,
wherein said pattern of the wavelength selection layer is formed by:

forming a thin film, which is a thin film formed of a material identical to that of the second top layer of the stacked film in said halfway of the basic step and having an optical film thickness set in accordance with a selection wavelength of one arbitrary filter part from among filter parts, on the stacked film; and
etching a portion other than a portion corresponding to said one arbitrary filter part in the thin film formed on the stacked film.

**17.** A method for manufacturing the infrared optical filter according to claim 15,
wherein the method comprises the step of:

forming, through mask vapor deposition, the wavelength selection layer having mutually different optical film thicknesses at respective sites corresponding to each filter part, between a first $\lambda/4$ multilayer film-formation step of forming the first $\lambda/4$ multilayer film on one surface side of a substrate, and a second $\lambda/4$ multilayer film-formation step of forming the second $\lambda/4$ multilayer film on the opposite side of the first $\lambda/4$ multilayer film from the substrate side.

**18.** An infrared optical filter that controls infrared rays in a wavelength range from 800 nm to 20000 nm, comprising:

a semiconductor substrate; and
a wide-band blocking filter part formed on one surface side of the semiconductor substrate,
wherein the wide-band blocking filter part is formed of a multilayer film in which a plurality of kinds of thin films having different refractive indices are stacked, and
wherein at least one kind of thin film from among said plurality of kinds of thin films is formed of a far infrared absorbing material that absorbs far infrared rays.

**19.** The infrared optical filter according to claim 18, wherein the far infrared absorbing material is an oxide or a nitride.

**20.** The infrared optical filter according to claim 18, wherein the far infrared absorbing material is $Al_2O_3$.

**21.** The infrared optical filter according to claim 18, wherein the far infrared absorbing material is $Ta_2O_5$.

**22.** The infrared optical filter according to claim 18, wherein the far infrared absorbing material is $SiN_x$.

**23.** The infrared optical filter according to claim 18, wherein the far infrared absorbing material is $SiO_x$.

**24.** The infrared optical filter according to any one of claims 18 to 23, wherein the multilayer film is formed by alternately stacking the thin film formed of Ge, being a material having a higher refractive index than the far infrared absorbing material, and the thin film formed of the far infrared absorbing material.

**25.** The infrared optical filter according to any one of claims 18 to 23, wherein the multilayer film is formed by alternately stacking the thin film formed of Si, being a material having a higher refractive index than the far infrared absorbing material, and the thin film formed of the far infrared absorbing material.

**26.** The infrared optical filter according to any one of claims 18 to 25, wherein the semiconductor substrate is a Si substrate.

*Fig. 1*

*Fig. 2*

*Fig. 3*

*Fig. 4*

Fig. 5

Fig. 6

## Fig. 7

Fig. 8A

Fig. 8B

Fig. 8C

Fig. 8D

Fig. 8E

*Fig. 9*

*Fig. 10*

Fig. 11

*Fig. 12*

*Fig. 13*

*Fig. 14A*

*Fig. 14B*

| Wavelength (nm) | Refractive index | Absorption coefficient |
|---|---|---|
| 350 | 1.6870 | 0.0000 |
| 400 | 1.6800 | 0.0000 |
| 450 | 1.6770 | 0.0000 |
| 500 | 1.6730 | 0.0000 |
| 550 | 1.6710 | 0.0000 |
| 600 | 1.6700 | 0.0000 |
| 650 | 1.6680 | 0.0000 |
| 700 | 1.6670 | 0.0000 |
| 4000 | 1.6670 | 0.0000 |
| 6000 | 1.5800 | 0.0000 |
| 7500 | 1.5600 | 0.0200 |
| 9000 | 1.5500 | 0.1000 |
| 10500 | 1.5400 | 0.3500 |
| 11250 | 1.5300 | 0.6000 |
| 12000 | 1.5250 | 0.9500 |
| 13500 | 1.5250 | 1.2000 |
| 15000 | 1.5250 | 1.3000 |

Fig. 15

Fig. 16

*Fig. 17A*

*Fig. 17B*

*Fig. 17C*

*Fig. 17D*

## Fig. 18

## Fig. 19

*Fig. 20*

*Fig. 21*

**INTERNATIONAL SEARCH REPORT**

| | International application No. |
|---|---|
| | PCT/JP2010/051620 |

A. CLASSIFICATION OF SUBJECT MATTER
*G02B5/28*(2006.01)i, *C23C14/06*(2006.01)i, *G02B5/22*(2006.01)i

According to International Patent Classification (IPC) or to both national classification and IPC

B. FIELDS SEARCHED

Minimum documentation searched (classification system followed by classification symbols)
G02B5/28, C23C14/06, G02B5/22

Documentation searched other than minimum documentation to the extent that such documents are included in the fields searched
Jitsuyo Shinan Koho          1922-1996   Jitsuyo Shinan Toroku Koho   1996-2010
Kokai Jitsuyo Shinan Koho    1971-2010   Toroku Jitsuyo Shinan Koho   1994-2010

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| Y | JP 10-78510 A  (Yokogawa Electric Corp.), 24 March 1998 (24.03.1998), paragraphs [0003], [0010] to [0012]; fig. 2 to 4 (Family: none) | 1-17,26 |
| X | JP 51-14032 B1  (Hitachi, Ltd.), 06 May 1976 (06.05.1976), column 1, line 22 to column 2, line 17; fig. 1, 2 (Family: none) | 18,19,23,24 |
| Y | | 1,2,4,6,7, 11,12,14-17, 20-22,25,26 |
| Y | JP 3-215803 A  (Minolta Camera Co., Ltd.), 20 September 1991 (20.09.1991), claims 1, 4 (Family: none) | 3,8,20,26 |

| ☒ Further documents are listed in the continuation of Box C. | ☐ See patent family annex. |
|---|---|

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| 28 April, 2010 (28.04.10) | 18 May, 2010 (18.05.10) |

| Name and mailing address of the ISA/ | Authorized officer |
|---|---|
| Japanese Patent Office | |
| Facsimile No. | Telephone No. |

Form PCT/ISA/210 (second sheet) (July 2009)

**INTERNATIONAL SEARCH REPORT**

| International application No. |
|---|
| PCT/JP2010/051620 |

C (Continuation).   DOCUMENTS CONSIDERED TO BE RELEVANT

| Category* | Citation of document, with indication, where appropriate, of the relevant passages | Relevant to claim No. |
|---|---|---|
| Y | WO 2005/069376 A1  (Matsushita Electric Industrial Co., Ltd.), 28 July 2005 (28.07.2005), description, page 10, line 12 to page 11, line 16; fig. 4 & US 2006/0205107 A1    & EP 1592067 A1 & KR 10-2006-0008275 A   & CN 1717808 A | 5,16 |
| Y | JP 2005-266538 A  (Stanley Electric Co., Ltd.), 29 September 2005 (29.09.2005), paragraphs [0007] to [0010]; fig. 1 (Family: none) | 9,13,21,25 |
| Y | JP 2004-252214 A  (Santec Corp.), 09 September 2004 (09.09.2004), paragraph [0134] (Family: none) | 10,22 |
| Y | JP 7-244215 A  (Nikon Corp.), 19 September 1995 (19.09.1995), claims 1 to 3; fig. 1 (Family: none) | 17 |

Form PCT/ISA/210 (continuation of second sheet) (July 2009)

<table>
<tr><td>**INTERNATIONAL SEARCH REPORT**</td><td>International application No.<br>PCT/JP2010/051620</td></tr>
</table>

**Box No. II    Observations where certain claims were found unsearchable (Continuation of item 2 of first sheet)**

This international search report has not been established in respect of certain claims under Article 17(2)(a) for the following reasons:

1. ☐ Claims Nos.:
   because they relate to subject matter not required to be searched by this Authority, namely:

2. ☐ Claims Nos.:
   because they relate to parts of the international application that do not comply with the prescribed requirements to such an extent that no meaningful international search can be carried out, specifically:

3. ☐ Claims Nos.:
   because they are dependent claims and are not drafted in accordance with the second and third sentences of Rule 6.4(a).

**Box No. III    Observations where unity of invention is lacking (Continuation of item 3 of first sheet)**

This International Searching Authority found multiple inventions in this international application, as follows:

See extra sheet

1. ☐ As all required additional search fees were timely paid by the applicant, this international search report covers all searchable claims.

2. ☒ As all searchable claims could be searched without effort justifying additional fees, this Authority did not invite payment of additional fees.

3. ☐ As only some of the required additional search fees were timely paid by the applicant, this international search report covers only those claims for which fees were paid, specifically claims Nos.:

4. ☐ No required additional search fees were timely paid by the applicant.    Consequently, this international search report is restricted to the invention first mentioned in the claims; it is covered by claims Nos.:

**Remark on Protest**      ☐ The additional search fees were accompanied by the applicant's protest and, where applicable, the payment of a protest fee.

☐ The additional search fees were accompanied by the applicant's protest but the applicable protest fee was not paid within the time limit specified in the invitation.

☐ No protest accompanied the payment of additional search fees.

Form PCT/ISA/210 (continuation of first sheet (2)) (July 2009)

**INTERNATIONAL SEARCH REPORT**

International application No.

PCT/JP2010/051620

Continuation of Box No.III of continuation of first sheet(2)

The technical feature common to the invention of claim 1 and the invention of claims 6-17 is in that "a substrate and filter parts formed on one surface of the substrate are provided, and each filter part comprises: a first λ/4 multilayer film in which a plurality of kinds of thin films having different refractive indexes and a same optical film thickness are laminated; a second λ/4 multilayer film which is arranged on the reverse side of the substrate-side surface of the first λ/4 multilayer film and in which the plurality of kinds of thin films are laminated; and a wavelength-selective layer which is arranged between the first λ/4 multilayer film and the second λ/4 multilayer and has an optical film thickness that is differentiated from the optical film thickness of the other thin films in accordance with the selected wavelength".  The technical feature, however, cannot be considered as a special technical feature since it does not define a contribution over the prior art in view of the disclosure of JP 10-78510 A (Yokogawa Electric Corp.), 24 March 1998 (24.03.1998), paragraphs [0003], [0010]-[0012], fig. 2-4.  In addition, there is no other same or corresponding special technical feature between these inventions.

Meanwhile, the technical feature common to the invention of claim 1 and the invention of claims 18-26 is in that "a substrate and filter parts formed on one surface of the substrate are provided, and each filter part is composed of a multilayer film in which a plurality of kinds of thin films having different refractive indexes are laminated".  The technical feature, however, cannot be considered as a special technical feature since it does not define a contribution over the prior art in view of the disclosure of JP 10-78510 A (Yokogawa Electric Corp.), 24 March 1998 (24.03.1998), paragraphs [0003], [0010]-[0012], fig. 2-4. In addition, there is no other same or corresponding special technical feature between these inventions.

Consequently, the invention of claims 1-5 and the invention of claims 6-26 do not satisfy the requirement of unity of invention.

Form PCT/ISA/210 (extra sheet) (July 2009)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2005069376 A
- JP S5858441 B
- JP 2001228086 A
- JP H5346994 B
- JP 2006039736 A
- JP 2003227751 A

**Non-patent literature cited in the description**

- **Mitsunobu Kobiyama.** Optical Thin-Film Filters. The Optronics Co., Ltd, 102-106